# EUROPÄISCHE PATENTSCHRIFT

(11) **EP 2 164 050 B1**
(45) Veröffentlichungstag und Bekanntmachung des Hinweises auf die Patenterteilung: **08.08.2018**
(21) Anmeldenummer: 09169914.0
(22) Anmeldetag: 10.09.2009
(51) Int. Cl.: G07C 7/00, G01P 1/02, G01D 11/24, H05K 5/02

(54) **Gehäuse für Fahrtenschreiber**
Casing for tachograph
Boîtier pour tachygraphe

(30) Priorität: 16.09.2008 DE 102008047449
(43) Veröffentlichungstag der Anmeldung: 17.03.2010
(73) Patentinhaber: Continental Automotive GmbH, 30165 Hannover (DE)
(72) Erfinder: Kirner, Herbert, 78052 Villingen-Schwenningen (DE); Wahler, Torsten, 78073 Bad Dürrheim (DE)

(56) Entgegenhaltungen:
- EP-A2- 0 892 334
- WO-A1-2006/028665
- CA-A1- 2 225 268
- DE-U1- 9 211 360
- US-A- 5 877 697
- US-A1- 2005 219 046

## Beschreibung

Die vorliegende Erfindung betrifft ein Gehäuse, insbesondere ein Gehäuse für Geräte wie Fahrtenschreiber, Mauterfassungssysteme oder dergleichen in Kraftfahrzeugen.

In der neuesten Generation von Fahrtenschreibern werden nicht mehr wie bisher Diagrammblätter mit den fahrer- bzw. fahrzeugrelevanten Daten beschrieben. Stattdessen werden diese Informationen nun in elektronischen Geräten bzw. auf einer in einem elektronischen Gerät beschriebenen Karte gespeichert. Da sich digitale Daten mit relativ wenig Aufwand manipulieren lassen können, muss sichergestellt sein, dass der unberechtigte Zugriff auf diese Daten komplett ausgeschlossen ist. Sollte, beispielsweise zu Reparatur- oder Wartungszwecken, ein Öffnen des Gehäuses notwendig sein, sollte dieses außerdem in einem entsprechenden Fehlerspeicher registriert werden mit Datum und Uhrzeit, um sicherzustellen, dass es sich hierbei um ein beabsichtigtes und autorisiertes Öffnen des Gehäuses handelt.

Es sind Systeme bekannt, bei denen ein Versiegeln eines Gehäuses eines Fahrtenschreibers durch Aufkleben eines Siegels erfolgt. Hier lässt sich ein Aufreißen des Siegels klar detektieren. Problematisch ist allerdings, dass diese Siegel auch nachgeahmt werden könnten bzw. auch dass beim häufigen Gebrauch dieser Siegel durch übereinanderliegende Siegelschichten Unklarheiten auftreten können bzw. dass sich ein unschönes Erscheinungsbild ergibt. Es sind auch Systeme bekannt, wie bspw. aus WO 2006/028665, bei denen das Gehäuse einen elektrischen Schalter umfasst. Wenn das Oberteil von dem Unterteil des Gehäuses entfernt wird, erzeugt der Schalter ein Manipulationssignal, so dass jeglicher Versuch zum unbefugten Öffnen des Gehäuses detektiert wird.

Ausgehend von diesem Stand der Technik stellt sich die Aufgabe, ein Gehäuse zur Verfügung zu stellen, das mit einer Sicherheitseinrichtung ausgelegt ist, die ein Öffnen des Geräts zuverlässig detektiert und den Gebrauch von Siegeln oder dergleichen überflüssig macht.

Diese Aufgabe wird durch ein Gehäuse nach Anspruch 1 gelöst.

Dies ist ein Gehäuse, insbesondere Gehäuse für Fahrtenschreiber, Mauterfassungssysteme oder dergleichen in Kraftfahrzeugen, enthaltend einen durch Bewegung entlang einer Mindestführungslänge aus einer Verschlusslage in eine Öffnungslage von dem restlichen Gehäuse trennbaren Gehäuseboden sowie eine elektrische Detektionseinrichtung zum Erkennen des Entfernens des Gehäusebodens, wobei die Detektionseinrichtung so ausgestaltet ist, dass sie ein Manipulationssignal spätestens nachdem 80% der Mindestführungslänge aus der Verschlusslage in Richtungsöffnungslage durchlaufen sind, erzeugt.

Zum sicheren mechanischen Verschluss ist der Gehäuseboden über eine vorzugsweise translatorische Führung mit dem restlichen Gehäuse verbunden. Hierdurch ist ein Mindestweg des Gehäusebodens kontrolliert zu durchlaufen bevor der Gehäuseboden von dem restlichen Gehäuse trennbar ist. Dieser Weg wird "Mindestführungslänge" genannt. Die elektrische Detektionseinrichtung ist nun so ausgeführt, dass sie ein Manipulationssignal spätestens nachdem 80% der Mindestführungslänge aus der geschlossenen und betriebsbereiten Lage (Verschlusslage) in Richtung Öffnungslage (also der Lage, in der der Gehäuseboden abgenommen werden kann, beispielsweise zu Wartungszwecken) durchlaufen sind, erzeugt.

Hierdurch wird sichergestellt, dass, bevor überhaupt von außen ein Zugriff auf elektronische Komponenten im Innenraum gegeben ist, bereits ein Detektionssignal abgegeben wird. Hierdurch wird es erschwert bzw. unmöglich, dass beim Abnehmen des Gehäusebodens beispielsweise ein Schraubendreher dazu genutzt wird, einen Schalter der Detektionseinrichtung zu betätigen, um ein Auslösen eines Manipulationssignals zu verhindern.

Vorteilhafte Weiterbildungen der Erfindung sind in den Unteransprüchen beschrieben.

Eine vorteilhafte Weiterbildung sieht vor, dass das Gehäuse quaderförmig ist. Dies kann also ein Standardgehäuse sein, wie es beispielsweise in DIN/ISO-Schächte in Mittelkonsolen moderner Kraftfahrzeuge eingebaut werden kann. Die in dem Gehäuse untergebrachte Elektronik kann die eines Fahrtenschreibers oder auch eines Mauterfassungssystems sein. Insbesondere bei diesen Anwendungen lohnt sich eine zuverlässige Detektion möglicher Gehäusemanipulation, da hier finanzielle oder auch rechtliche Konsequenzen von der Zuverlässigkeit der in dem Gehäuse gespeicherten Daten abhängen. Die Erfindung bietet sich allerdings auch für andere elektronische Geräte, beispielsweise Autoradios, Mobiltelefone etc. an, da hier oftmals auch rechtliche Fragen im Zusammenhang mit unbefugten Reparaturen während der Garantiezeit beachtlich sind.

Der Gehäuseboden ist nicht notwendigerweise die untere Fläche des Gehäuses, es kann auch eine andere beliebige Fläche des Gehäuses sein, beispielsweise die Oberseite oder die Rückseite.

Eine vorteilhafte Weiterbildung sieht vor, dass die Mindestführungslänge 6,5 mm, vorzugsweise 7,5 mm beträgt. Hiermit wird sichergestellt, dass ein mechanisch guter Verschluss gegeben ist, dies ist auch für Dichtigkeits- bzw. Stabilitätsanforderungen wichtig. Außerdem wird hierdurch gewährleistet, dass durch den seitlichen Versatz bzw. eine notwendige Schwenkung entlang einer vorgegebenen Führung ein Eingriff mittels externer Werkzeug (z. B. Schraubenzieher) nicht möglich ist, bevor die Detektionseinrichtung nicht ein Signal abgegeben hat.

Eine weitere vorteilhafte Weiterbildung sieht vor, dass die Führung zwischen Gehäuseboden und dem restlichen Gehäuse als Anordnung ausgeführt ist, bei der mindestens eine Lasche bezüglich eines korrespondierenden Schlitzes translatorisch führbar ist. Diese Anordnung ist insbesondere bei Metallblechteilen kostengünstig herstellbar und langlebig.

Eine weitere vorteilhafte Weiterbildung sieht vor, das Gehäuse eine in einem Kraftfahrzeuginnenraum richtbare Bedienfront aufweist. Dies ist beispielsweise bei Fahrtenschreibern bzw. Mauterfassungssystemen der Fall, bei denen bei Fahrtantritt durch den Fahrer bestimmte Daten nochmals eingegeben werden müssen.

Die Trennung des Gehäusebodens ist vorzugsweise durch translatorische Bewegung in Richtung senkrecht zur Bedienfront, an der dem des Kraftfahrzeuginnenraum abweisenden Seite der Bedienfront, möglich.

Der Gehäuseboden ist vorzugsweise als Metallblechteil ausgeführt, wodurch sich eine günstige Herstellungsweise ergibt und außerdem der Vorteil, dass der Gehäuseboden auch elektrisch leitend ist.

Das Gehäuse kann eine elektrische Platinen enthaltende Einrichtung zur Speicherung und Verarbeitung von Daten, insbesondere zur Speicherung von strecken- und fahrerbezogenen Daten eines Kraftfahrzeugs, enthalten. Hierbei sind vorzugsweise eine Displayleiterplatte (zur Darstellung von an der Bedienfront angezeigten Informationen) sowie des Weiteren im Inneren des Gehäuses weitere Leiterplatten, beispielsweise eine Systemleiterplatte und/oder eine Outsert-Platine angebracht. Hierbei ist es vorteilhaft, dass durch räumlich verschachtelte Anordnung der Leiterplatten besonders sensible elektronische Bauteile geschützt bzw. versteckt sind, so dass ein Austausch dieser Teile zur Datenmanipulation weiter erschwert wird.

Eine weitere vorteilhafte Weiterbildung sieht vor, dass der Gehäuseboden in Verschlusslage mit dem übrigen Gehäuse zusätzlich verschraubt, verklebt oder durch korrespondierende Rastverbindungen verbunden ist. Hierdurch wird ein unbeabsichtigtes Lösen des Gehäusebodens aus der Verschlusslage in die Öffnungslage zusätzlich verhindert. Die Erfindung gemäß Anspruch 1 sieht ebenfalls vor, dass eine Leiterplatte einer im Gehäuse angeordneten elektronischen Einrichtung einen Schlitz sowie einen den Schlitz überragenden Schwenkstößel eines mechanischen Schalters aufweist und der Gehäuseboden eine zu dem Schlitz komplementäre Lasche aufweist, die so gestaltet ist, dass in der Verschlusslage die Lasche in den Schlitz eingreift und den Schwenkstößel gedrückt hält. Hieran ist vorteilhaft, dass der Schalter wiederum integral auf der Leiterplatte angeordnet werden kann. Das Eingreifen der Lasche des Gehäusebodens in den Schlitz bewirkt durch den Formschluss ein sicheres Schalten. Die Ausführung des Schalters als Druckschalter mit Schwenkstößel sorgt dafür, dass durch Querkräfte der Druckschalter nicht blockiert wird bzw. stockt bzw. ungenau anspricht, da ein Abgleiten der Lasche am Schwenkstößel leicht möglich ist. Um das Einführen der Lasche in den Schlitz zu erleichtern, kann der Schlitz eine Einlaufschräge aufweisen. Die Lasche weist vorzugsweise eine in den Schlitz ragbare Ausformung zur Versteifung und zur Verbreiterung der Lasche auf. Hierdurch wird die Lasche zum einen gegen Vibrationen weniger anfällig und zum anderen auch gegen ein Verbiegen geschützt, so dass das Auslösen des Schalters/Schwenkstößels mit noch höherer Sicherheit erfolgt.

Diese Ausführungsform sieht vorzugsweise vor, dass der verwendete Gehäuseöffnungsschalter mit einem Schwenkstößel versehen ist.

Dabei ist bei dem favorisierten Schalter der Stößel drehbar gelagert, so dass die Querkräfte minimal sind. Die geometrische Anordnung des Gehäuseöffnungsschalters und das Design des Schwenkstößels sind derart ausgelegt, dass unter Krafteinwirkung durch die Betätigungslasche des Gehäusebodens in Schiebrichtung dieser Schwenkstößel sich über seinen Drehpunkt radial bewegt.

Hier wird vom definierten Schaltzustand "Schließen" in den Schaltzustand "Öffnen" über den Verfahrweg der Betätigungslasche gefahren.

Die Betätigungslasche am Gehäuseboden kann für diese Lösung einfach und prozesssicher gestaltet werden.

Ein in der zugehörigen Systemleiterplatte befindliches Profil erlaubt es, sich trotz der Toleranzaufsummierung der verschiedenen in Eingriff zueinander stehenden Bauteile zueinander zu positionieren.

Die Betätigungslasche wird aufgrund ihrer Elastizität in die Funktionslage gebracht.

Durch die Zwangsführung der Betätigungslasche in der Systemleiterplatte ist eine Pegeländerung am Schalter durch Vibrationen und Schwingungen ausgeschlossen.

Damit wird der Schwenkstößel im Rahmen seiner technischen Spezifikation betätigt.

Die Ausführungsform hat folgende Vorteile:
- Der favorisierte Schalter wird wie in der in seiner Spezifikation beschriebenen Anwendung verwendet;
- die durch die Betätigungslasche erzeugten Querkräfte werden minimiert;
- durch die Zwangsführung der Betätigungslasche wird die Schwenkstößelbewegung genau definiert;
- die aufsummierten Toleranzen der in Eingriff zueinander stehenden Bauteile werden durch das direkte Einwirken von Betätigungslasche und Schwenkstößel reduziert;
- die Funktionssicherheit über die Herstelltoleranzen der Bauteile wird durch diese Anordnung abgefangen, es kann eine kostengünstige Herstellung erfolgen;
- die Montagefreisparung in der Systemleiterplatte lässt eine automatische Positionierung des Gehäusebodens (Gerätemontage) ohne hohen technischen Aufwand zu;
- die Detektion des Signals erfolgt in einem hierfür kurzen Verfahrweg des Gehäusebodens und kleine relative Bewegungsvorgänge des Gehäusebodens zum Gehäuse werden als Manipulation erkannt und im Fehlerspeicher hinterlegt;
- die gesamte Anordnung wie: Schwenkstößel-Schalter, Montagefreisparung und Kontur für Zwangsführung auf der Systemleiterplatte sowie Betätigungslasche des Gehäusebodens liegen im Gerät derart angeordnet, dass eine Manipulation von Außen ohne sichtbare Spuren nicht erfolgen kann.

Die Erfindung wird nun anhand von Figuren erläutert. Es zeigen:
- Fign. 1a bis In: Ansichten einer ersten Ausführungsform,
- Fign. 2a bis 2q: Ansichten einer zweiten Ausführungsform,
- Fign. 3a bis 3f: Ansichten einer dritten Ausführungsform,
- Fign. 4a bis 4ab: Ansichten einer vierten Ausführungsform, und
- Fign. 5a bis 5z: Ansichten einer erfindungsgemäßen Ausführungsform eines Gehäuses.

Im Folgenden werden verschiedene Ausführungsformen erläutert. Allen gemeinsam ist, dass dort Gehäuse gezeigt sind, insbesondere Gehäuse für Fahrtenschreiber, Mauterfassungssysteme oder dergleichen in Kraftfahrzeugen, enthaltend einen durch Bewegung in einer Führung entlang einer Mindestführungslänge aus einer Verschlusslage in eine Öffnungslage von dem restlichen trennbaren Gehäuseboden sowie eine elektrische Detektionseinrichtung zum Erkennen des Entfernens des Gehäusebodens, wobei die Detektionseinrichtung so ausgestaltet ist, dass sie ein Manipulationssignal spätestens nachdem 80% der Mindestführungslänge aus der Verschlusslage in Richtung Öffnungslage durchlaufen sind, erzeugt.

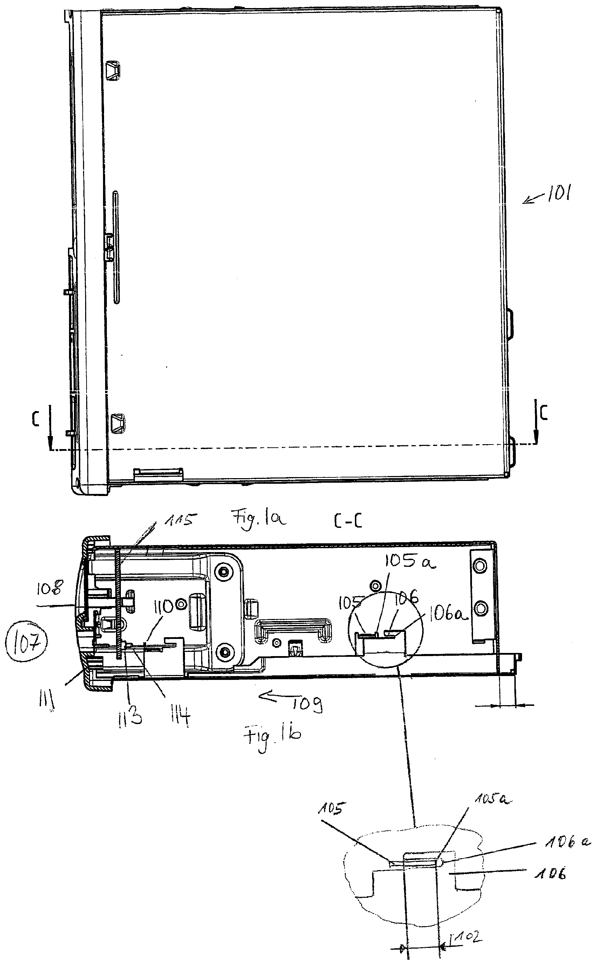

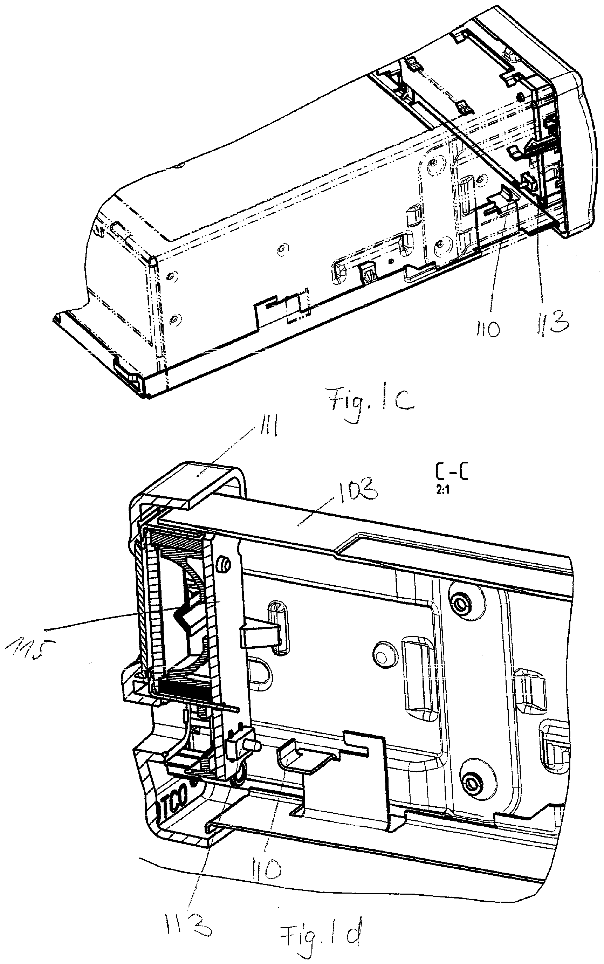

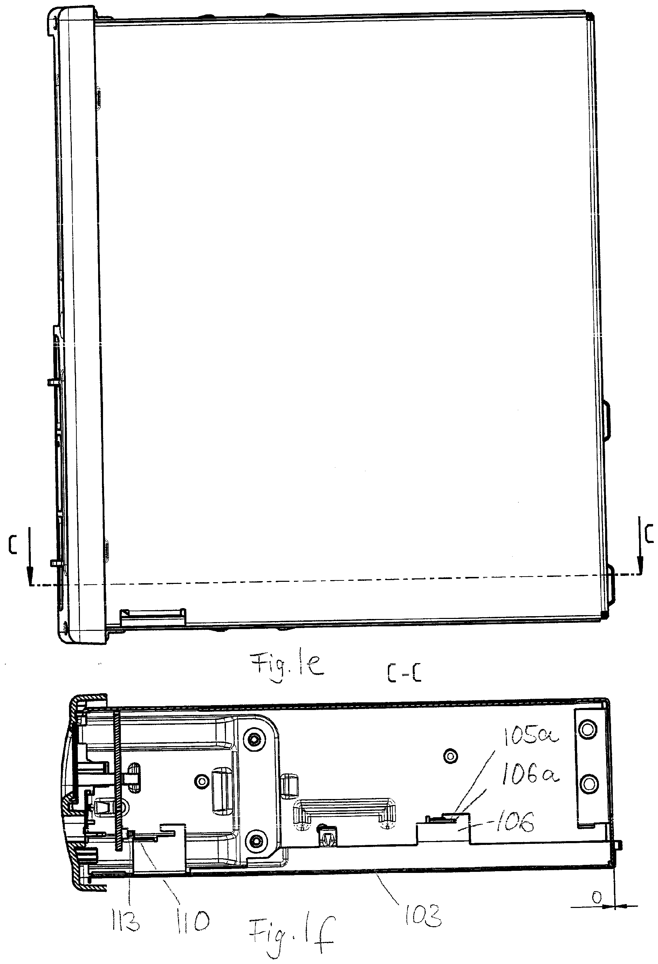

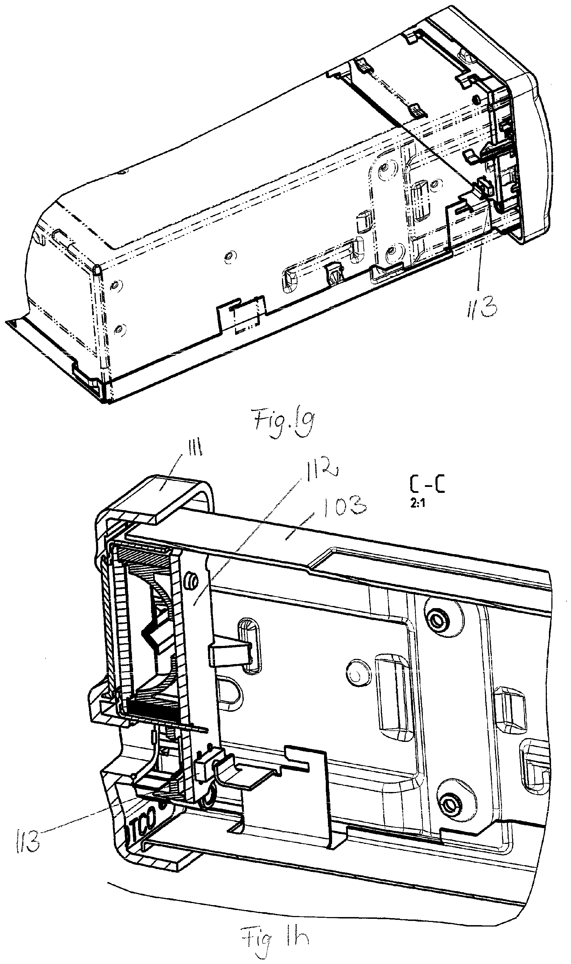

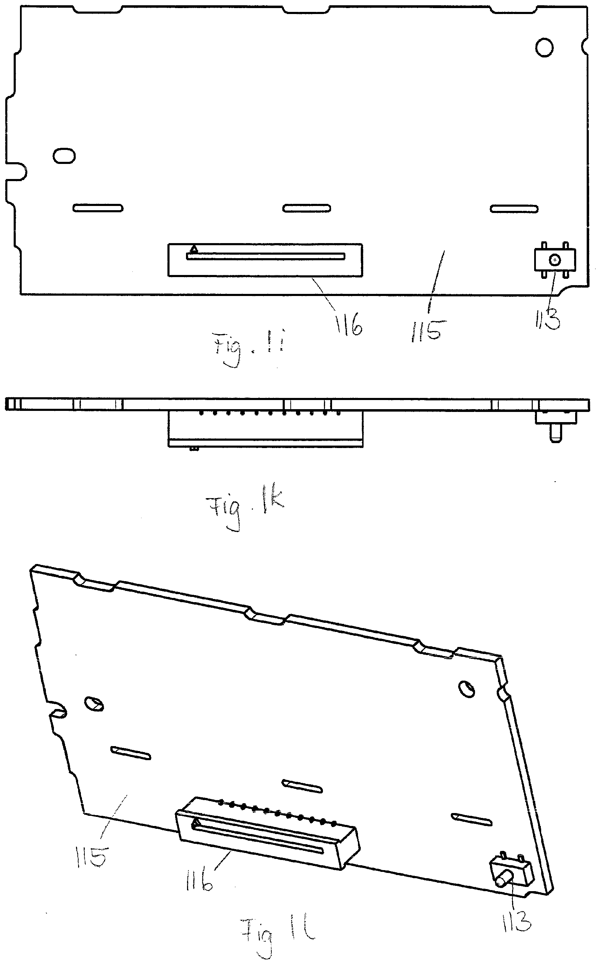

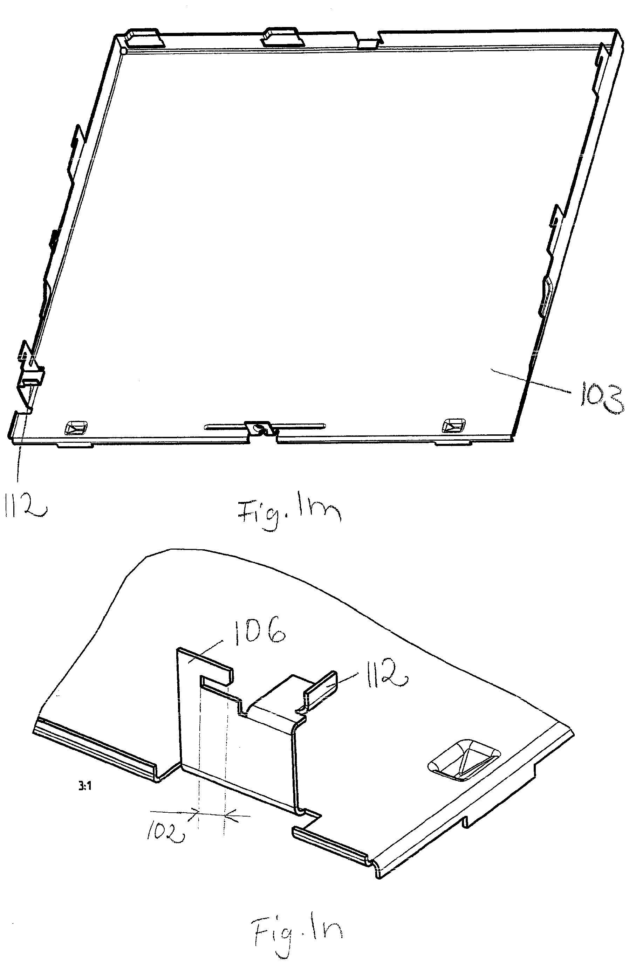

Fign. 1a bis 1m zeigen eine erste nicht beanspruchte Ausführungsform. Fig. 1a
zeigt eine Draufsicht auf ein Gehäuse 101 eines Fahrtenschreibers.

Fig. 1b
zeigt einen Schnitt gemäß C-C in einer Lage, bei der der Gehäuseboden 103 aufgelegt ist, der Schalter 113 bzw. dessen Druckknopf 114 allerdings noch nicht betätigt ist. Der Gehäuseboden weist Schlitze 106 auf, wobei jeweils vier Schlitze vorgesehen sind in dem Gehäuse, zwei an der linken Seite des Gehäuses (im Schnitt C-C zu sehen) und zwei entsprechend auf der rechten Seite des Gehäuses. Diese Schlitze greifen in Laschen 105 ein, die am restlichen Gehäuse angebracht sind. Die in Fig. 1b vergrößerte Detailzeichnung zeigt (im Gegensatz zu Fig. 1b, die eine Öffnungslage zeigt) den Zustand, bei dem die Laschen 105 bezüglich der Schlitz 106 in der Verschlusslage sind. Durch den Eingriff der Laschen 105 in die Schlitze 106 ist der Gehäuseboden fest mit dem übrigen Gehäuse verbunden, d. h., die "Verschlusslage" ist erreicht. Die Verschlusslage ist dadurch gekennzeichnet, dass die Lasche 105 nicht mehr weiter in den Schlitz 106 geführt werden kann. Dieser kann, muss aber nicht die Berührung mit dem Anschlag 106a bedeuten. In dieser Lage ist die Betätigungslasche 110 gegen den Druckknopf 114 des Schalters 113 gedrückt, so dass die Verschlusslage detektiert ist. Kommt es zu einem Verrücken des Gehäusebodens entgegen der Richtung 109, gibt es ein Manipulationssignal von der Detektionseinrichtung. Das Detektionssignal wird ausgelöst bei Bewegung der Vorderkante 105a, aus der Verschlusslage in Richtung 109, wenn 80% der Mindestführungslänge 102 durchlaufen sind. In diesem Zustand ist der Gehäuseboden 103 einerseits noch fest mit dem übrigen Gehäuse verbunden, so dass ein Eingriff von Schraubenziehern etc. kaum möglich ist, andererseits ist der Schalter 113 bereits nicht mehr im Eingriff, so dass ein Manipulationssignal abgegeben wird. Es ist hierbei vorteilhaft, dass bereits vor Erreichen des Endes der Mindestführungslänge das Signal abgegeben wird, da zu diesem Zeitpunkt noch regelmäßig alle vier Führungen (bestehend aus Lasche 105 und Schlitz 106) in Eingriff sind.

Der Verdeutlichung dieser Verhältnisse dienen insbesondere die Fig. 1b, die den Gehäuseboden in einer Öffnungslage zeigt, sowie die Detailvergrößerung zur Fig. 1b (siehe Kreis), die eine Verschlusslage zeigt, bei der die Lasche 105 mit ihrer Vorderkante 105a fast an dem Anschlag 106a des Schlitzes 106 liegt.

Der Schalter 113 ist an einer Displayleiterplatte 115 befestigt, die Teil einer Frontblende 111 aus Kunststoff ist. Eine Bedienfront 108 ist mit ihrer Vorderseite zu einem Kraftfahrzeuginnenraum 107 hin angeordnet.

Das Gehäuse ist vorliegend quaderförmig ausgeführt und so dimensioniert, dass es in einen DIN/ISO-einfachen Standardschacht passt.

Die Mindestführungslänge 102 beträgt vorliegend 6,5 mm.

Das Gehäuse ist, abgesehen von der Frontblende 111, aus einem Metallblech und elektrisch leitend.

Das Gehäuse umfasst in sämtlichen Ausführungsformen im vorliegenden Beispiel einen Fahrtenschreiber, dieser enthält auch elektrische Platinen zur Speicherung und Verarbeitung von Daten, insbesondere zur Speicherung von streckenbezogenen Daten eines Kraftfahrzeugs, wobei vorzugsweise mindestens eine Displayleiterplatte, eine Outsertleiterplatte und eine Systemleiterplatte gegeben sind.

Fign. 1c und 1d
zeigen die Betätigungslasche 110 und den Schalter 113 im noch unbetätigten Zustand.

Fign. 1e und 1f
zeigen den Zustand, in dem der Gehäuseboden 103 in der Verschlusslage angeordnet ist. Hierbei ist es auch, wie bereits oben gesagt, möglich, dass die Vorderkante 105a der Lasche nicht bis zum Endanschlag des Schlitzes 106 reicht, um hier noch einen "Spielraum" zu haben.

Fign. 1g und 1h
zeigen die betätigte Stellung des Schalters 113.

Fign. 1i bis 1l
zeigen drei Ansichten der Displayleiterplatte 115, die auf der Rückseite der Frontblende 111 befestigt ist. Zu sehen ist ein auf der Displayleiterplatte angeordneter Schalter 113 sowie ein Stecker 116 für die Datenübertragung zur Systemleiterplatte.

Fign. 1m und 1n
zeigen einen Gehäuseboden 103 mit Betätigungslasche 112. Zu sehen hierbei wiederum, dass der Gehäuseboden als geformten Metallblechteil ausgeführt ist mit integraler Betätigungslasche 112, auch die maximale Mindestführungslänge 102 ist erkennbar.

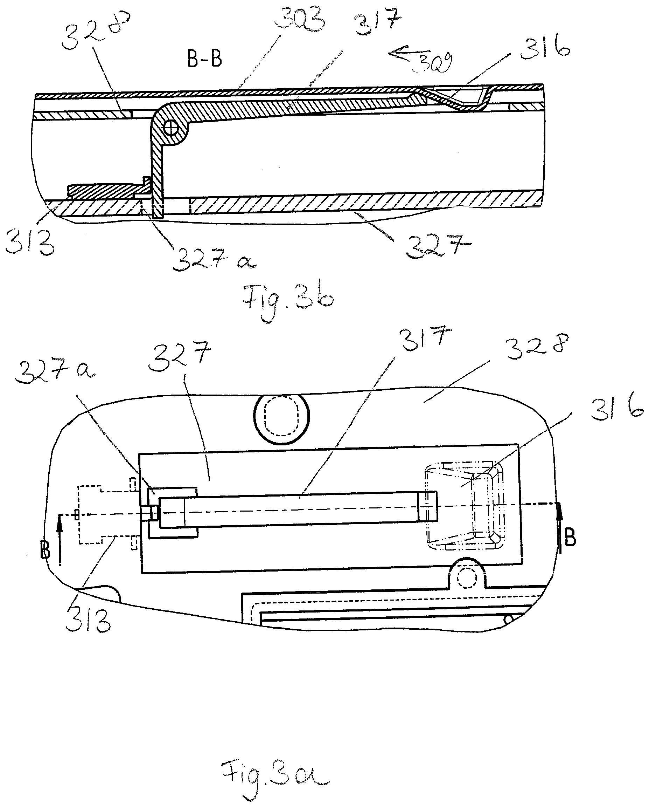

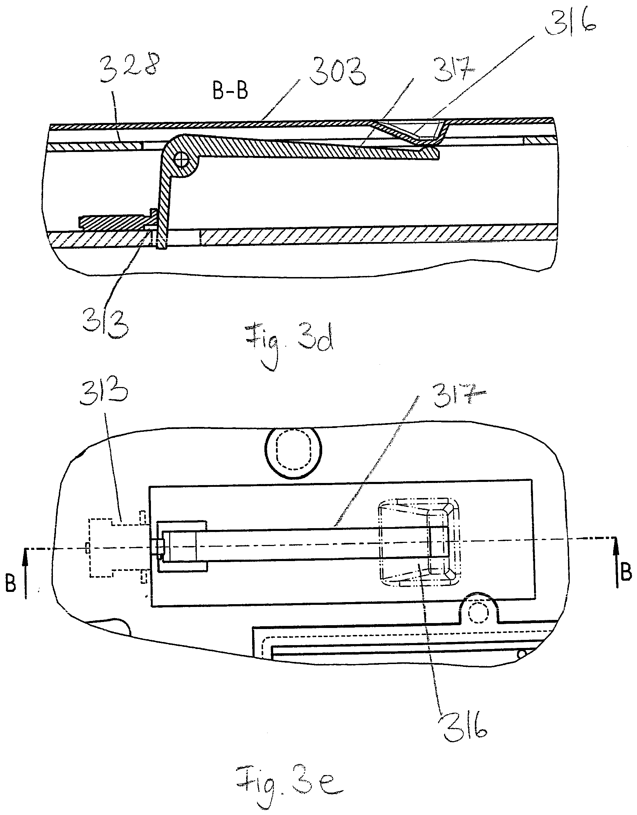

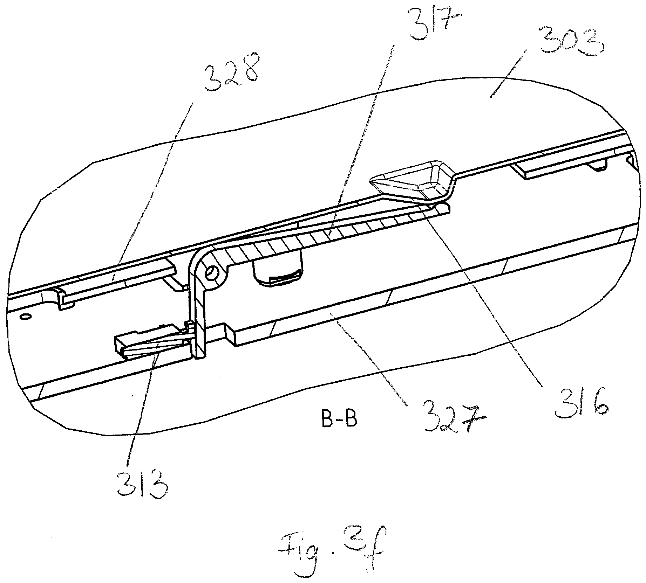

Fign. 2a bis 2q
zeigen eine zweite nicht beanspruchte Ausführungsform des Gehäuses. Hierbei sind alle Bezugszeichen mit einer vorangestellten "2" benannt. Bezugszeichen, die bei der ersten Ausführungsform mit einer vorangestellten "1" bezeichnet wurden und welche die letzten beiden Stellen mit den hier aufgeführten Bezugsziffern gemeinsam haben, sind entsprechende Gleichteile, auf die nicht weiter eingegangen werden soll. Dasselbe gilt entsprechend für die Ausführungsformen der übrigen Fign. 3a ff.

Fign. 2a und 2b
zeigen eine Draufsicht auf ein Gehäuse 201 mit einer Frontblende 211 und einem Gehäuseboden 203.

Fign. 2c bis 2f
zeigen Ansichten bzw. Details der Frontblende 211.

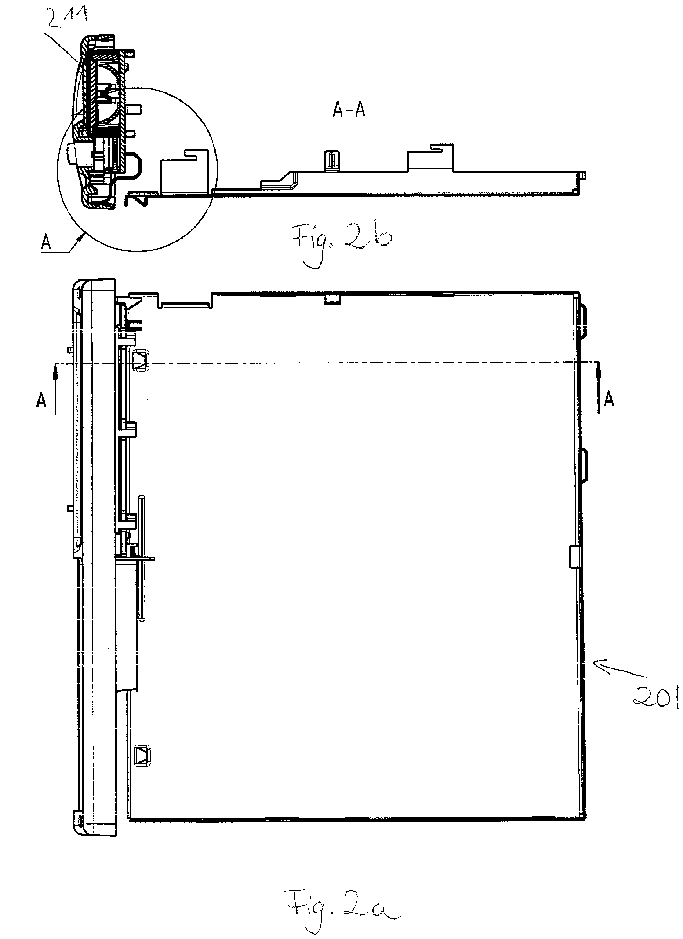

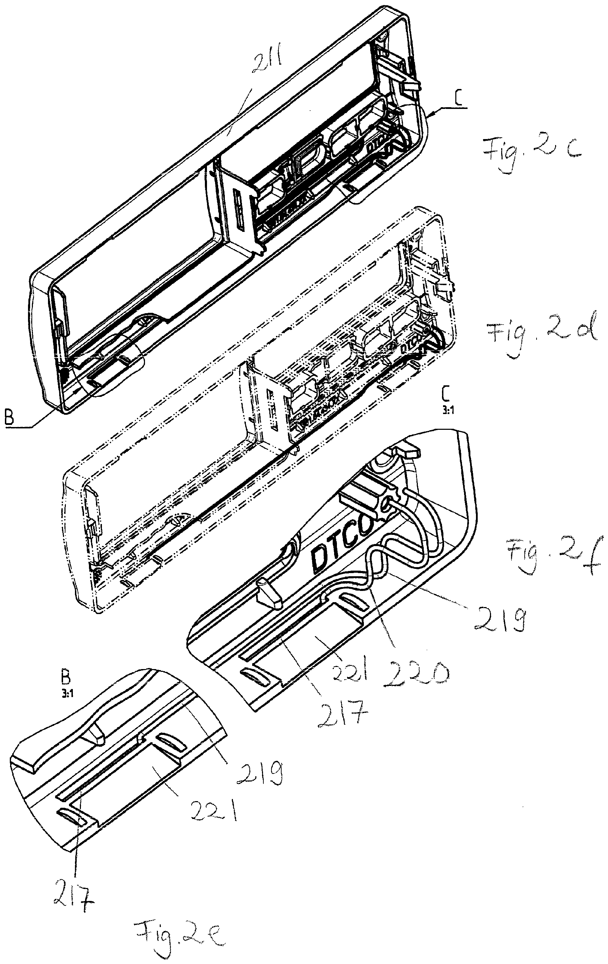

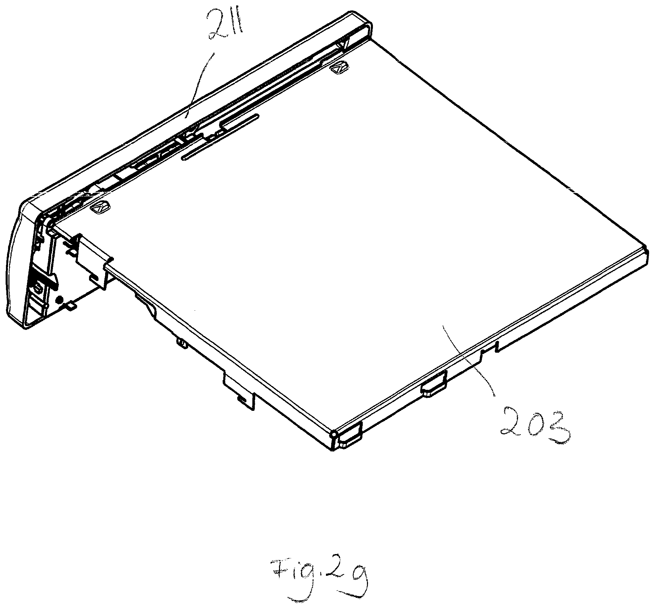

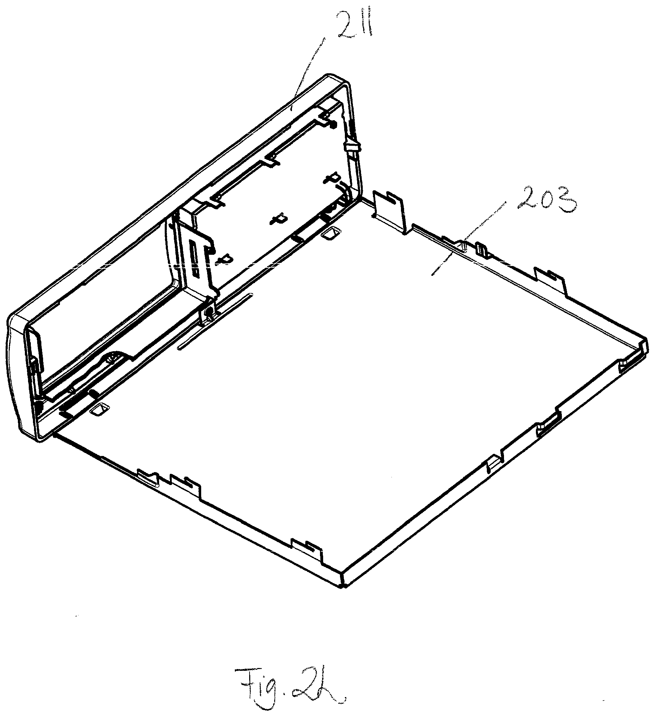

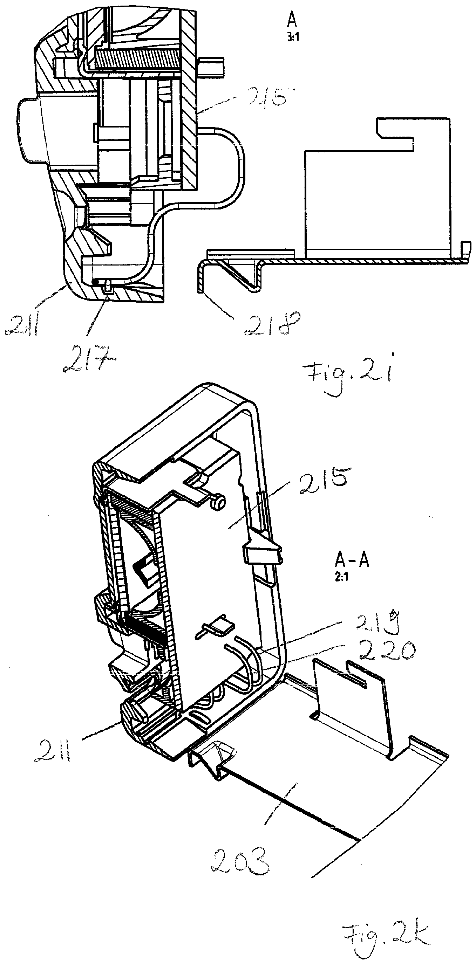

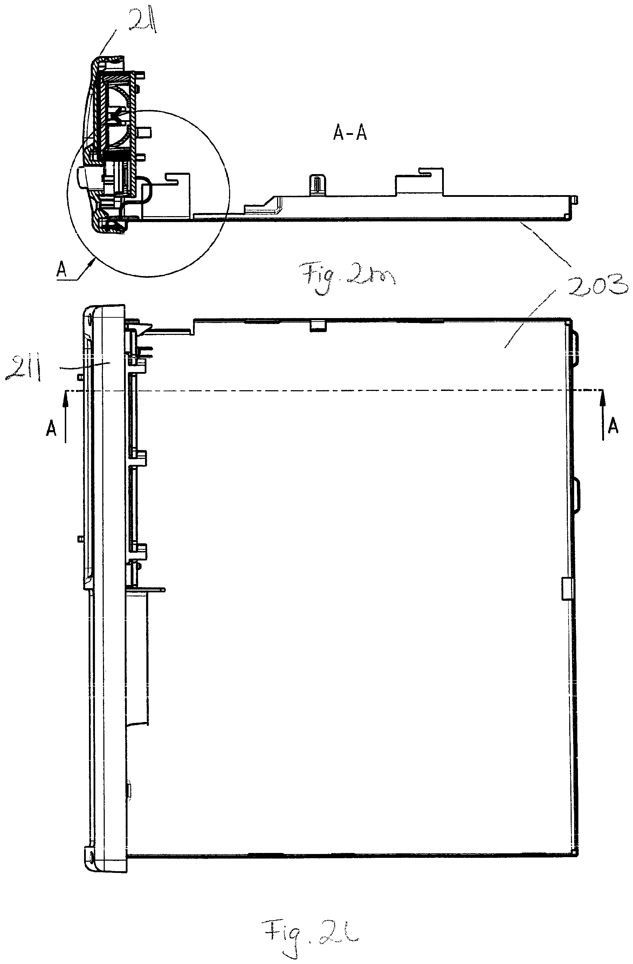

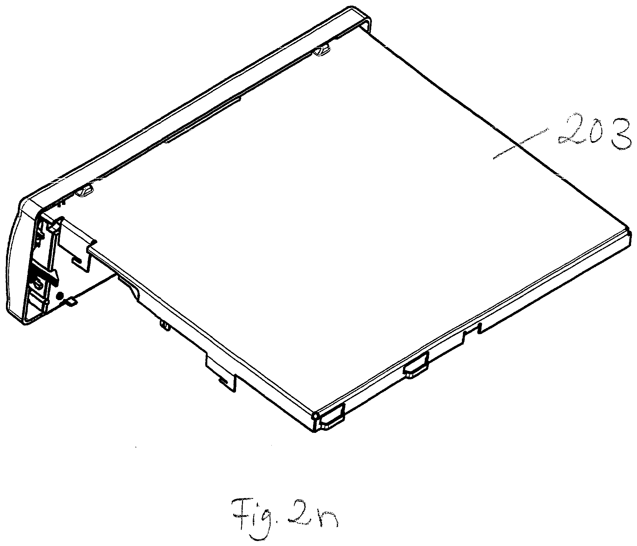

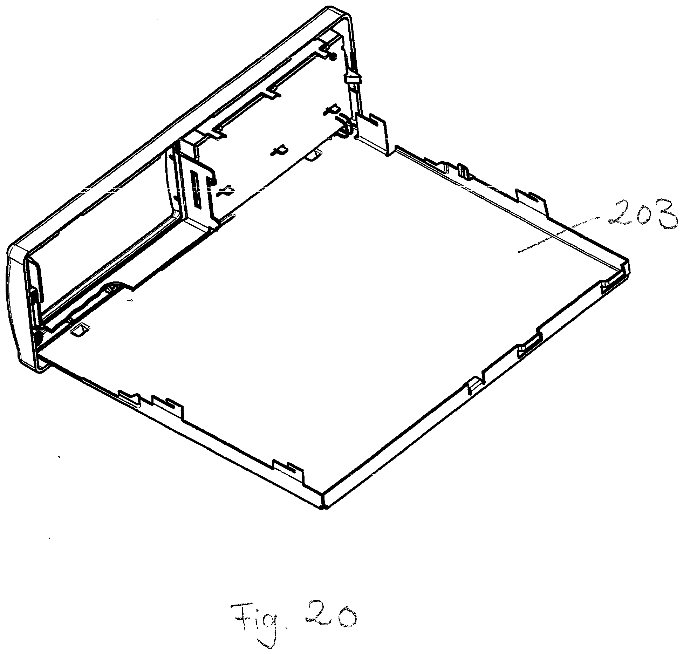

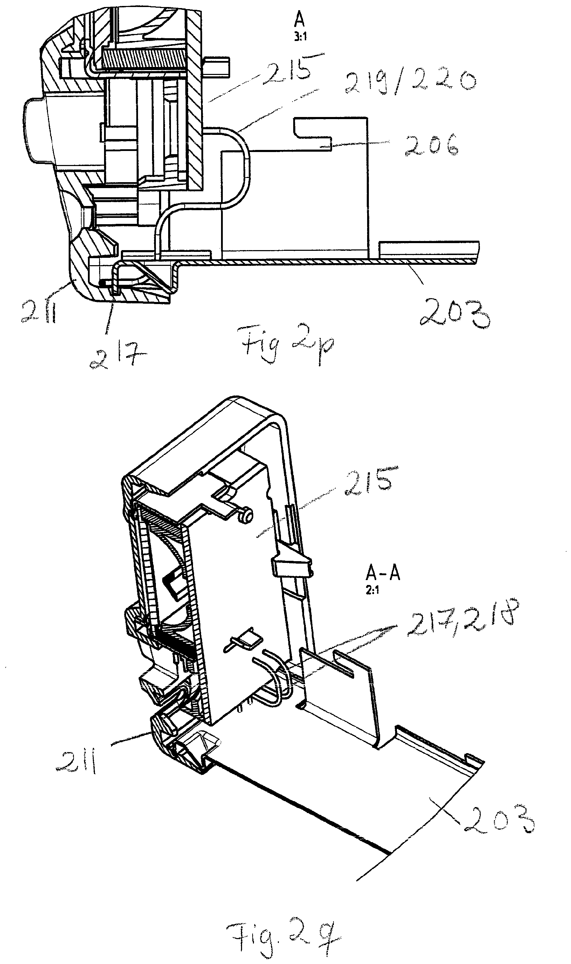

Detail B in Fig. 2e und Detail C in Fig. 2f
zeigen elektrische Leiter zu einem ersten Kontakt 219 und elektrische Leiter zu einem zweiten Kontakt 220. Diese elektrischen Leiter führen jeweils zu elektrischen Kontaktflächen in Vertiefungen, die erste Verbindungsteile 217 darstellen. In diese ersten Verbindungsteile 217 greifen in der Verschlusslage als Rastnasen ausgebildete zweite Verbindungsteile 218 ein, die am Gehäuseboden angeformt sind (die zweiten Verbindungsteile 218 sind insbesondere in Fig. 2i gut zu sehen). Vor den ersten Verbindungsteilen 217 sind Rampen 221 vorgesehen, die ein Einführen der als Rastnasen ausgeführten zweiten Verbindungsteile ermöglichen. Bei einem Eingriff der zweiten Verbindungsteile 218 kontaktieren diese Rastnasen die elektrischen Kontaktflächen in den Vertiefungen der ersten Verbindungsteile 217 und stellen so einen Kontakt zwischen erstem elektrischen Leiter 219 und zweitem elektrischen Leiter 220 her, so dass ein elektrischer Strom leitbar wird, der die Verschlusslage detektiert. Kommt es zu einem Herausbewegen des Gehäusebodens 203 aus dieser Verschlusslage, wird ein Detektionssignal von der Detektionseinrichtung abgegeben.

Fign. 2g und 2h
zeigen die Frontblende 211 und den Gehäuseboden 203 aus verschiedenen Ansichten.

Fign. 2i und 2k
zeigen nochmals detailliert das Bewegen der als Rastnasen ausgebildeten zweiten Verbindungsteile 218 in Richtung der Frontblende 211 mit den ersten Vertiefungsteilen 217, zu sehen ist hierbei auch die Displayleiterplatte 215, von der die elektrischen Leiter 219 und 220 abgehen.

Fign. 2m und 2l
zeigen weitere Ansichten des Gehäusebodens 203 und der Frontblende 211.

Fign. 2n bis 2q
zeigen die Endstellung (Verschlusslage) bei dem der Gehäuseboden 203 vollständig geschlossen ist und die zweiten Verbindungsteile 218 in den ersten Verbindungsteilen 217 festgesteckt sind.

Fign. 3a bis 3f
zeigen Ausschnitte aus einem Gehäuse 303. Insbesondere ist ein quaderförmiges Gehäuse gezeigt mit einem Gehäuseboden 303, der mit dem restlichen Gehäuse über eine Führung translatorisch verbindbar ist. Hierzu sind nicht dargestellte Schlitze (vier auf jeder Seite, siehe Fig. 1b) vorgesehen, die in vier entsprechende Laschen (siehe ebenfalls Fig. 1b) eingreifen.

In den Fign. 3a bis 3f werden der Einfachheit halber lediglich die entscheidenden unterschiedlichen Aspekte gegenüber den anderen Ausführungsformen gezeigt. Dies ist insbesondere ein zu einem Schalter gehörender Kipphebel 317, der einen ersten horizontalen Schenkel aufweist (siehe Fig. 3b) und rechtwinklig dazu angeordnet einen vertikal nach unten gerichteten Schenkel. Im Schnittpunkt beider Schenkel ist der Drehpunkt des Kipphebels als Gelenkachse ausgeführt.

Wie in Fig. 3b zu sehen, ist der rechte Endpunkt des horizontal liegenden Schenkels im Eingriff mit einer Anlauframpe 316. Der mittlere Abschnitt des vertikal stehenden Schenkels steht im Eingriff mit einem mechanischen Druckschalter 313.

Der Gehäuseboden 303 wird in Richtung 309 verschoben, um den Gehäuseboden mit dem restlichen Gehäuse in die Verschlusslage zu bringen. Hierbei läuft die rechte Spitze des horizontalen Schenkels des Kipphebels 317 nach rechts unten entlang der Anlauframpe bis in den daran anschließen horizontalen Bereich. Hierdurch wird der vertikale Schenkel des Kipphebels nach links geschwenkt, so dass der Schalter 313 in seiner betätigten Stellung ist. In dieser betätigten Stellung erkennt die Detektionseinrichtung eine Verschlusslage. Beim Herausbewegen aus der Verschlusslage, d. h. bei einem Bewegen des Gehäusebodens entgegen der Richtung 309 um mindestens 80% des Betrags der Mindestführungslänge, gerät der Schalter 313 außer Eingriff und es gibt ein Manipulationssignal der Detektionseinrichtung.

Der translatorische Auslöser des Schalters 313 ist an der Systemleiterplatte 327 angebracht, das Gelenk/der Drehpunkt des Kipphebels 317 ist an einer hiervon verschiedenen Outsertplatine 328 befestigt. Beide Platinen (Outsertplatine 328 und Systemleiterplatte 327) sind in fester räumlicher Beziehung zueinander, so dass ein sicheres Auslösen gewährleistet ist.

Wie in Fig. 3a gut zu sehen ist, ist der Kipphebel 317 in einer entsprechenden Aussparung der Outsertplatine 328 angebracht, so dass der horizontal verlaufende Schenkel des Kipphebels zum Gehäuseboden 303 hin durchgreifen kann. Die Systemleiterplatte 327 hat außerdem in einer Aussparung, in die der vertikale Schenkel des Kipphebels 317 eintaucht, einen Ausschnitt sowie einen Anschlag 327a, der dazu dient, ein zu weites Vorrücken des Schenkels und damit eine Beschädigung des übrigen Schalters 313 zu vermeiden.

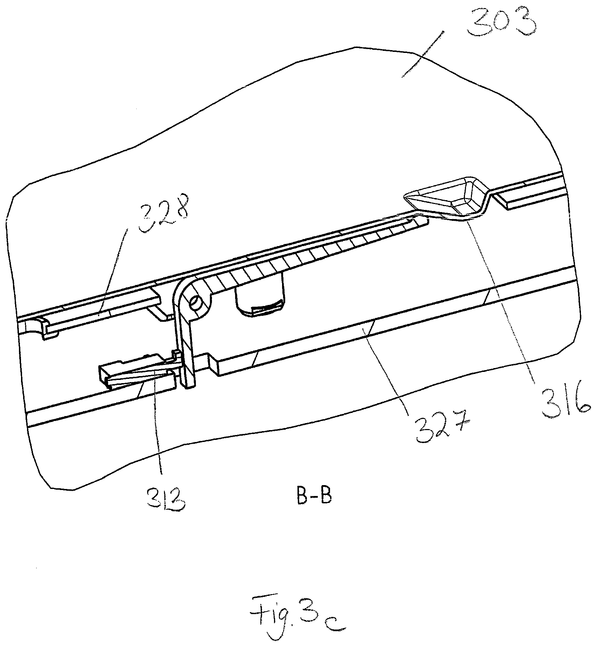

Aus Fig. 3a und 3c sind weitere Details zur Geometrie von Kipphebel 317 und Anlauframpe 316 gegeben.

Fig. 3f
zeigt noch einmal den Zustand der Verschlusslage, in der der Kipphebel 317 hinuntergedrückt ist mit dem rechten horizontalen Schenkel, die Spitze des Schenkels liegt hierbei an einem im Wesentlichen horizontalen Abschnitt des Gehäusebodens 303 an.

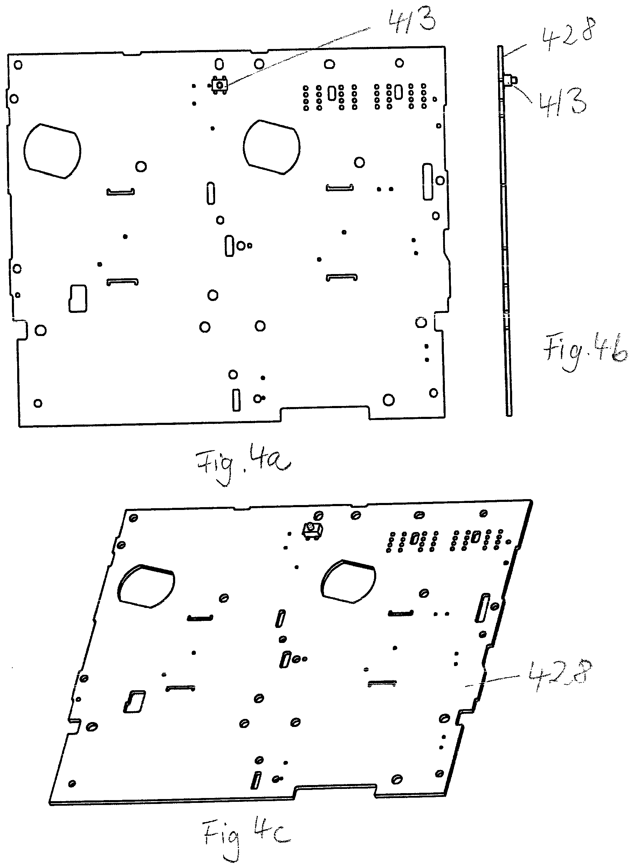

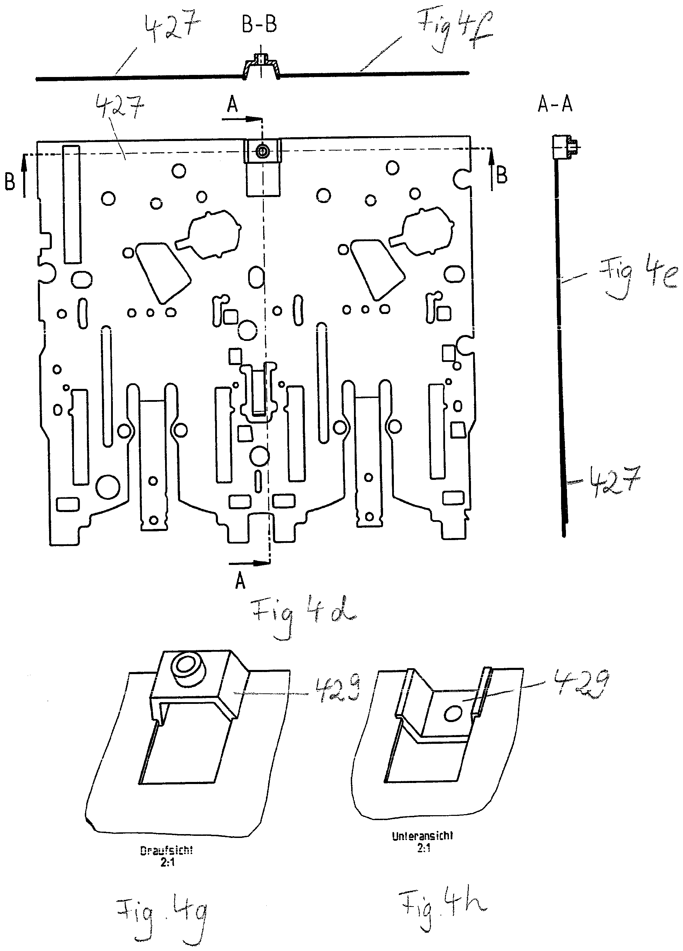

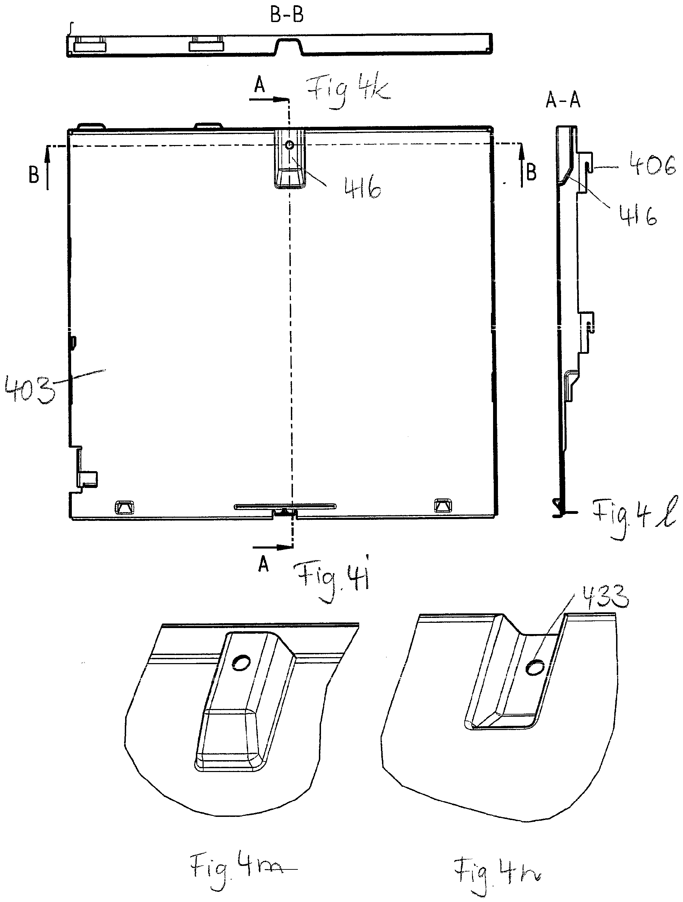

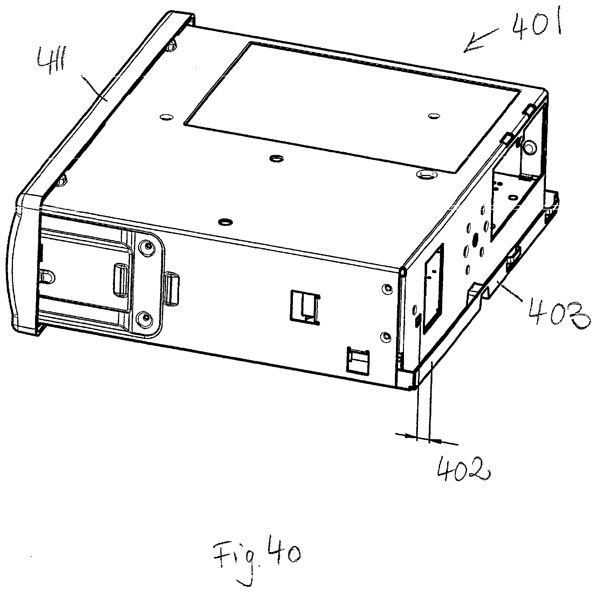

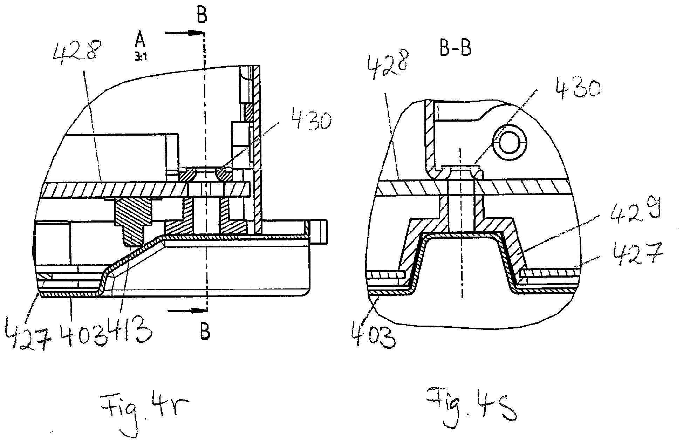

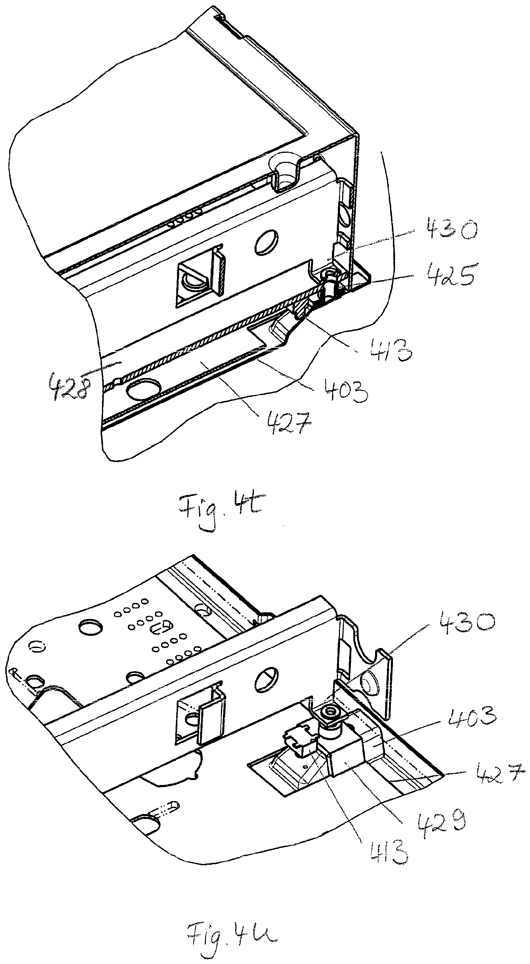

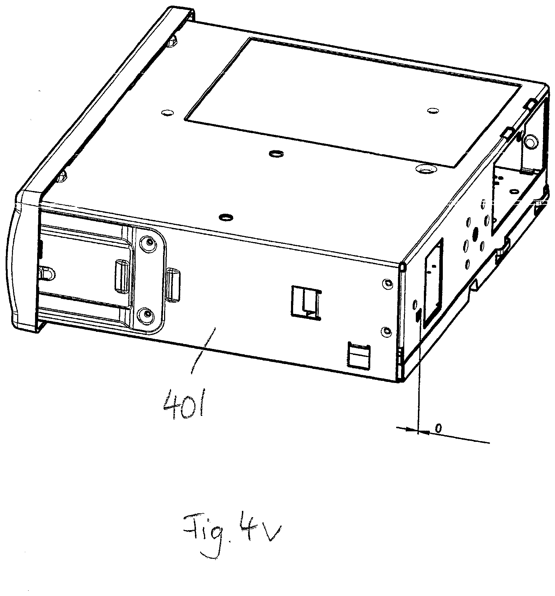

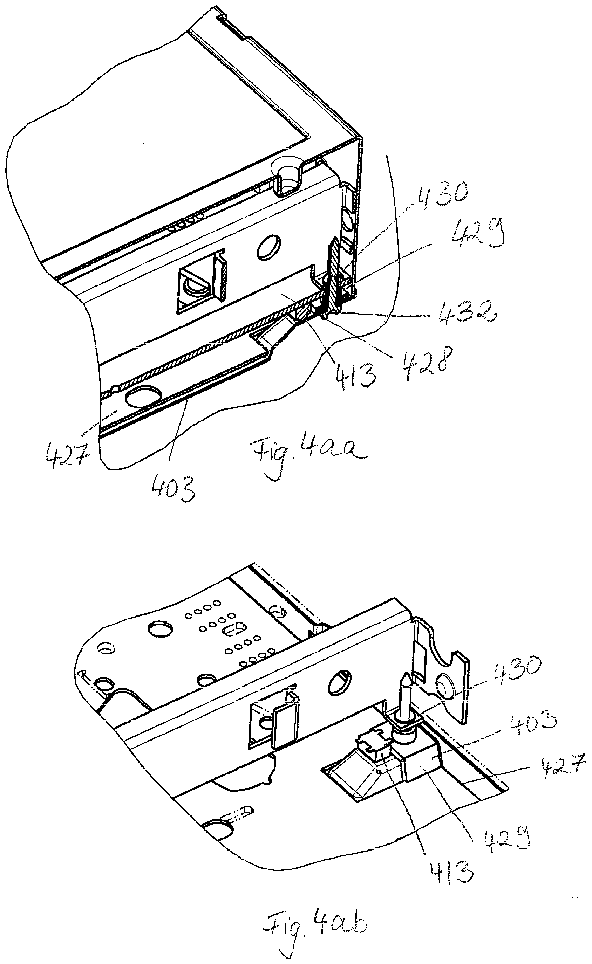

Fign. 4a bis 4ab
zeigen eine weitere nicht beanspruchte Ausführungsform eines Gehäuses. Fign. 4a, 4b und 4c
zeigen verschiedene Ansichten einer teilweise noch unbestückten Systemleiterplatte, auf der ein Schalter 413 (translatorischer Druckschalter, Schaltungsrichtung senkrecht zur Hauptebene der Systemleiterplatte) aufgebracht ist.

Fign. 4d, 4e und 4f
zeigen eine Outsertplatine 427, in deren Mitte (siehe Fig. 4f) ein Outsertelement 429 gut erkennbar ist. Dieses Outsertelement ist nochmals in Fign. 4g (Draufsicht Maßstab 3:1) und in Fig. 4h (Unteransicht, Maßstab 2:1) gezeigt. In Fig. 4g ist unterhalb des Outsertelements 429 eine Aussparung in der Outsertplatine gegeben, in die eine Betätigungssicke bzw. Anlauframpe eingreifen kann. Das Outsertelement erfüllt die Funktion als Anschraubdom und als Abstandshalter zur Verringerung von Einbautoleranzen.

Fign. 4i, 4k und 4l
zeigen verschiedene Ansichten eines Gehäusebodens 403. Dieser weist eine eingeprägte Anlauframpe 416 auf. In der in Fig. 4l gezeigten Seitenansicht sind außerdem Schlitze 406, hiervon gibt es insgesamt vier Stück (zwei auf jeder Seite des Gehäusebodens, Details hierzu finden sich in Fign. 1a ff.). Die Details der Führung, bei denen hier nicht dargestellte Laschen in die Schlitze eingreifen und über einer Mindestführungslänge aus der Verschlusslage hinaus in eine Öffnungslage gebracht werden können, sind in Fign. 4a ff. nicht im Einzelnen dargestellt, hier sind allerdings die Verhältnisse genauso wie in der ersten Ausführungsform nach Fig. 1a ff., so dass zur Vermeidung von Wiederholungen hier nicht weiter darauf eingegangen wird.

Fig. 4m
zeigt eine Innenansicht der Anlauframpe/Sicke vom Gehäuseinneren aus.

Fig. 4n
zeigt eine Ansicht vom äußeren Haus, zu sehen ist auch eine Anschraubbohrung 433 im Bereich der Sicke.

Fig. 4o
zeigt eine perspektivische Außenansicht des kompletten Gehäuses 401 mit Frontblende 411, hierbei ist der Gehäuseboden 403 um die Mindestführungslänge 402 bereits nach hinten herausgezogen, so dass ein Manipulationssignal von der Detektionseinrichtung abgegeben ist.

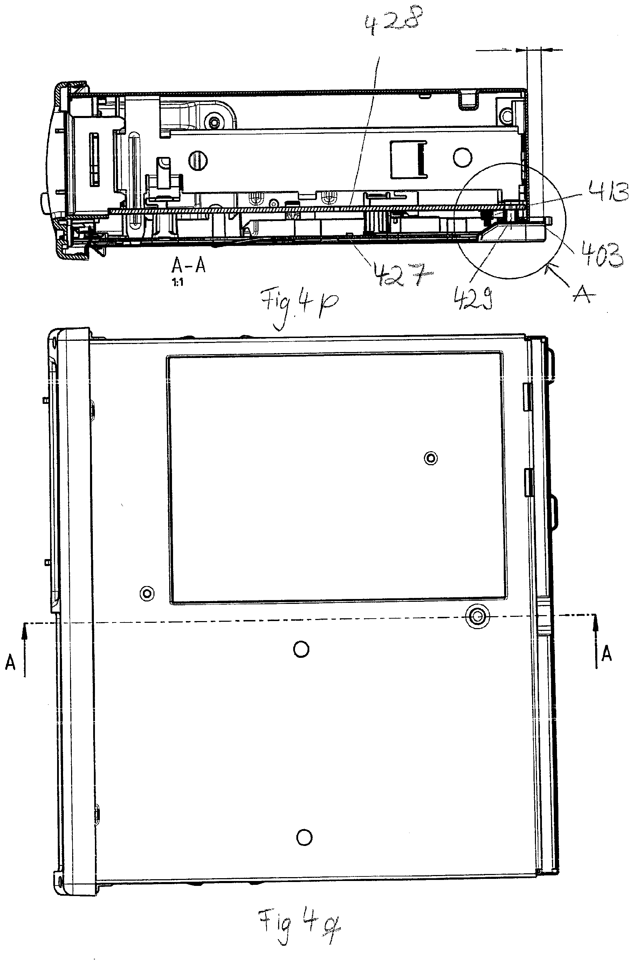

Weitere Ansichten hierzu finden sich in Fign. 4p und 4q.

Fig. 4p
zeigt einen seitlichen Schnitt gemäß A-A, hier ist die Outsertplatine 427 gesehen mit dem darin angeordneten Outsertelement, wobei das Outsertelement auf einem Gehäuseboden 403 ruht um somit einen definierten Abstand zur Systemleiterplatte 428 herzustellen. Auf der Systemleiterplatte 428 ist der Schalter 413 angebracht, der auf einem schrägen Abschnitt der Anlauframpe des Gehäusebodens 403 ruht. In der in Fig. 4p bzw. 4q gezeigten Stellung ist der Schalter nicht betätigt, so dass sich hier ein Manipulationssignal ergibt, da es hier um eine Öffnungslage handelt.

Fign. 4r und 4s
zeigen zwei Detailzeichnungen zu dieser Öffnungslage.

Fig. 4r
zeigt eine Vergrößerung des unbetätigten Schalters 413 (translatorischer Druckschalter, wirkend in vertikale Richtung). Das Outsertelement ist noch nicht mit einer Schraube bestückt, hierzu gibt es allerdings einen Anschraubpunkt 430 im Gehäuse, mit dem eine Schraube in der späteren Verschlusslage eine Befestigung zwischen Gehäuseboden und restlichen Gehäuse (also im Bereich des Anschraubpunkts 430) herstellen kann. Hierdurch wird außerdem eine "Versplintung" herbeigeführt, so dass der Gehäuseboden nicht nach horizontal rechts geschoben werden kann in der Fig. 4r gezeigten Lage.

Fig. 4s
zeigt einen weiteren Schnitt in einer senkrecht zu der in Fig. 4r gezeigten Lage. Hier ist wiederum die Abfolge Gehäuseboden 403, Outsertelement 429, Systemleiterplatte 428 sowie Anschraubpunkt 430 im übrigen Gehäuse zu sehen.

Fign. 4t und 4u
zeigen perspektivische Ansichten der oben genannten Öffnungslage, wobei in Fig. 4u dieses Systemleiterplatte 428 transparent dargestellt ist und nur durch eine strichpunktierte Linie angedeutet ist in ihren Umrissen.

Fig. 4v
zeigt die Verschlusslage des Gehäuses 401.

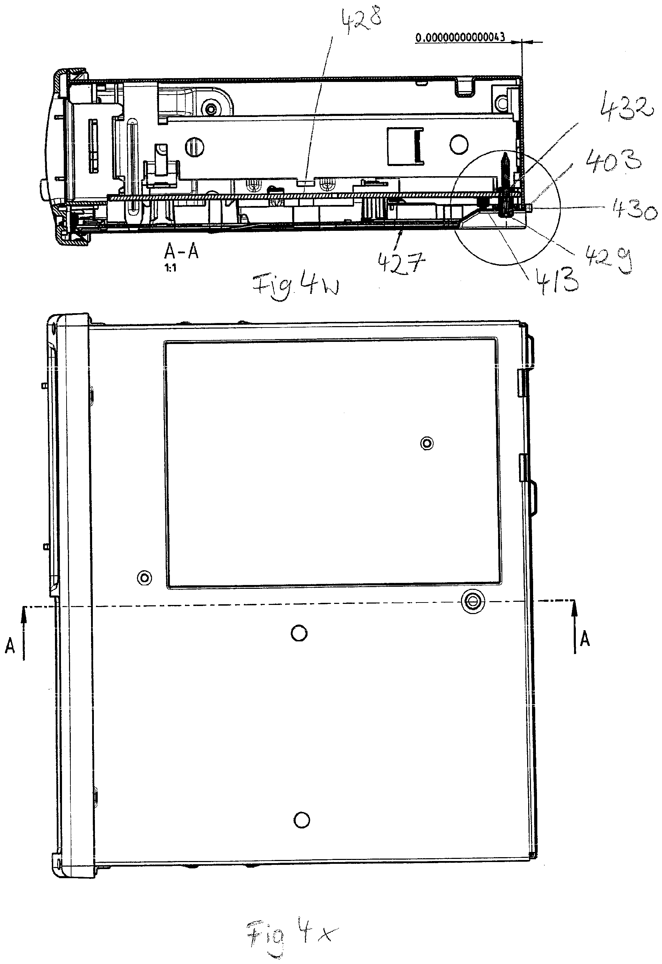

Im Schnitt gemäß A-A der Draufsicht von Fig. 4x sind in Fig. 4w weitere Einzelheiten zu sehen. Gezeigt ist hierbei auch eine Schraube 432, die verschiedene Elemente miteinander verbindet und die Verschlusslage garantiert.

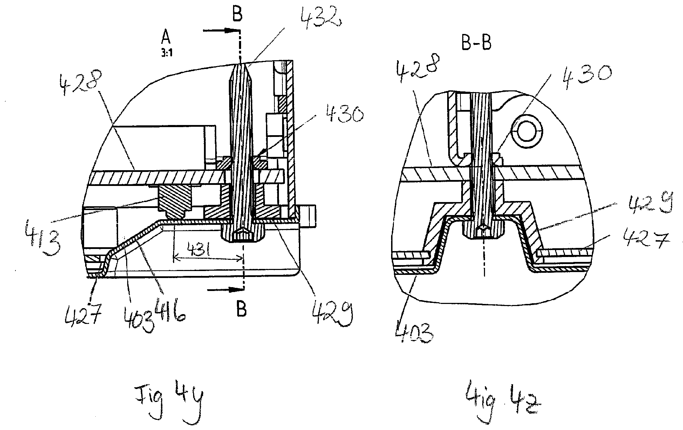

Nähere Einzelheiten hierzu sind in Fign. 4y und 4z zu sehen, die das Detail A aus Fig. 4w nochmals verdeutlichen.

Fig. 4y
zeigt die Verschlusslage des Gehäusebodens 403 bezüglich dem übrigen Gehäuse. In dieser Verschlusslage ist der Schalter 413 in gedrückter Position, so dass kein Manipulationssignal von der Detektionseinrichtung abgegeben wird. Eine Schraube 432 fixiert diese Lage, indem sie durch eine Bohrung im Gehäuseboden, eine dazu fluchtende Bohrung im Outsertelement sowie der Systemleiterplatte 428 geht und schließlich in einem Anschraubpunkt 430 im übrigen Gehäuse gehalten ist.

Die Schraube 432 ist, wie besonders gut in B-B gemäß Fig. 4z zu sehen, zurückgesetzt gegenüber dem übrigen Gehäuseboden. Hierdurch wird es möglich, ein zusätzliches Siegel aufzubringen, um bereits die Manipulation an der Schraube 432 zu erkennen. Die Anlauframpe 416 ist nicht mehr im Eingriff mit dem Schalter, da es sich hier um eine Verschlusslage handelt, bei der der Schalter 413 auf einem horizontalen Abschnitt der Gehäusesicke aufliegt.

Vorteilhaft ist, dass der Schalter 413 sehr nahe an dem Outsertelement 429 liegt und in diesem Bereich eine große Steifigkeit des Gehäuses durch die Verschraubung mit der Schraube 432 gegeben ist. Somit ist eine genau vorgegebene räumliche Beziehung zwischen Systemleiterplatte 428 und Gehäuseboden 403 und somit auch ein genaues Ansprechen des Schalters 413 gegeben. Die Entfernung 431 zwischen der Mittelachse der Schraube 432 (bzw. Mittelachse des Outsertelements 429) und der Mittelachse des Druckknopfes des Schalters bzw. des Schalters selbst beträgt lediglich ca. 2 cm, so dass sich eine sehr stabile und steife Konstruktion in diesem Bereich ergibt.

Fign. 4aa und 4ab
zeigen nochmals perspektivische Ansichten der Verschlusslage, wobei in Fig. 4ab mehrere Komponenten, beispielsweise die Systemleiterplatte nicht vollständig dargestellt sind, die Umrisslinie der Systemleiterplatte ist als Strichpunktierung dargestellt.

Fign. 5a bis 5z
zeigen eine Ausführungsform der Erfindung.

Fign. 5a bis 5c
zeigen eine Leiterplatte 535 mit einer am Rande befindlichen Schlitzanordnung.

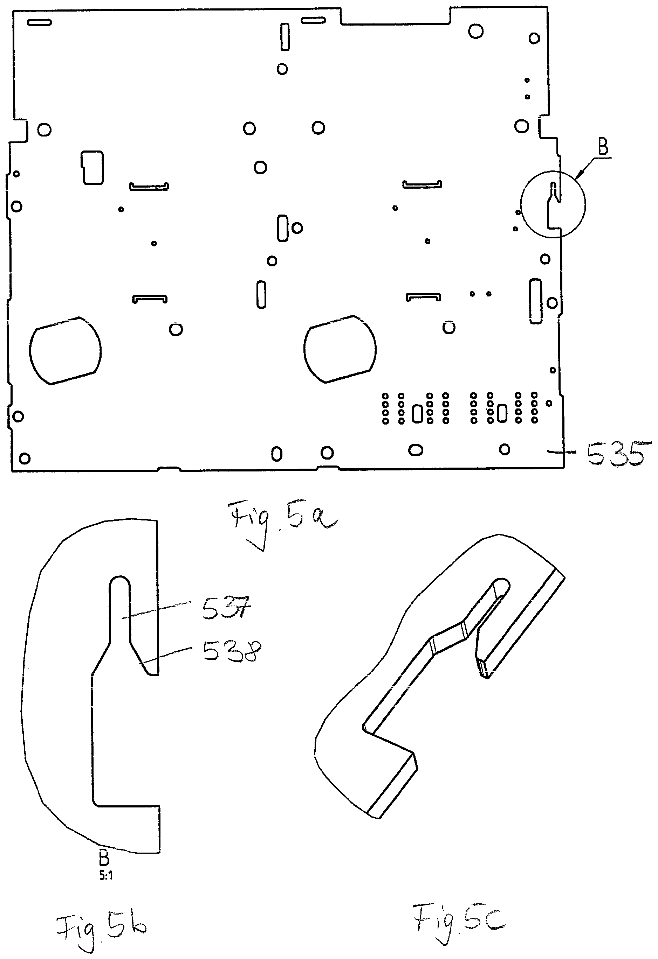

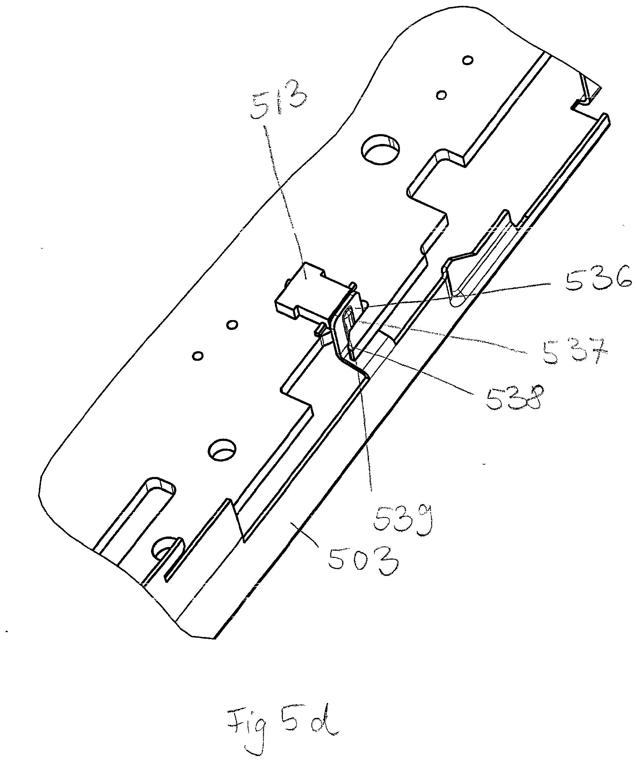

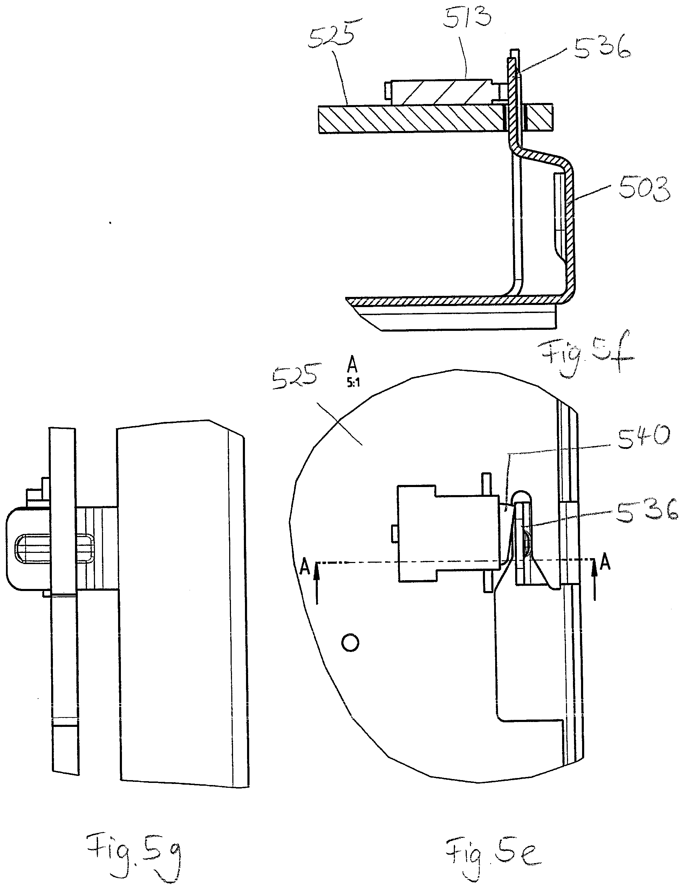

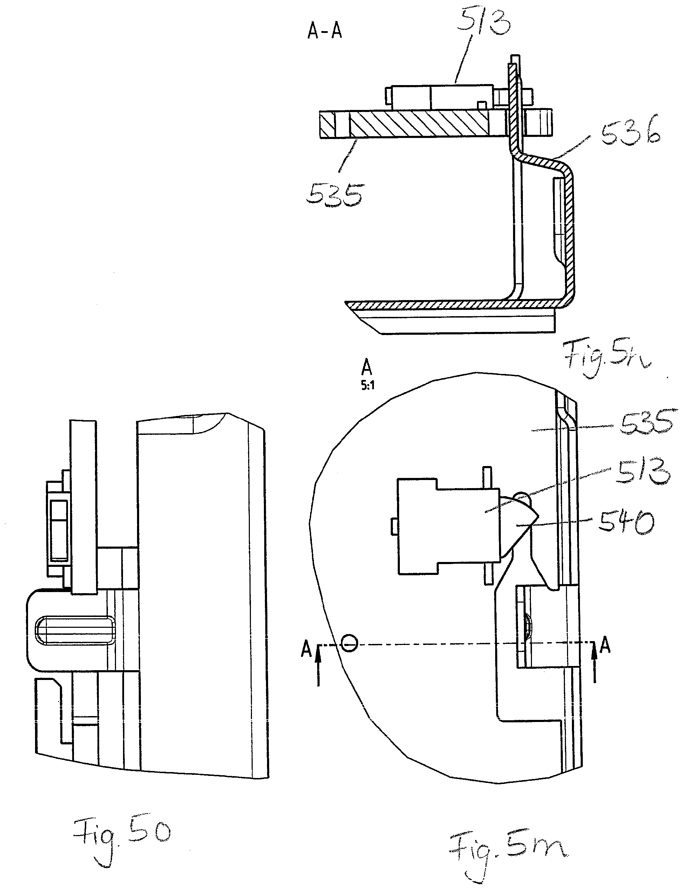

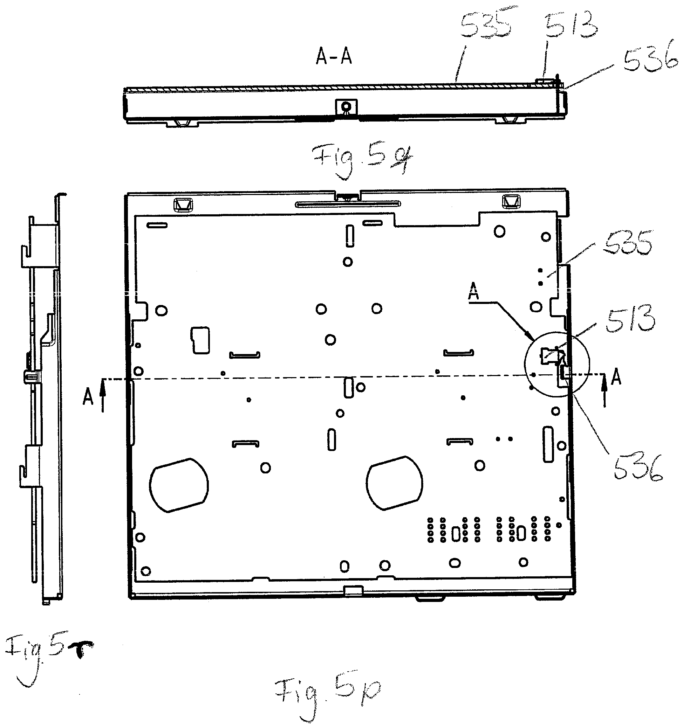

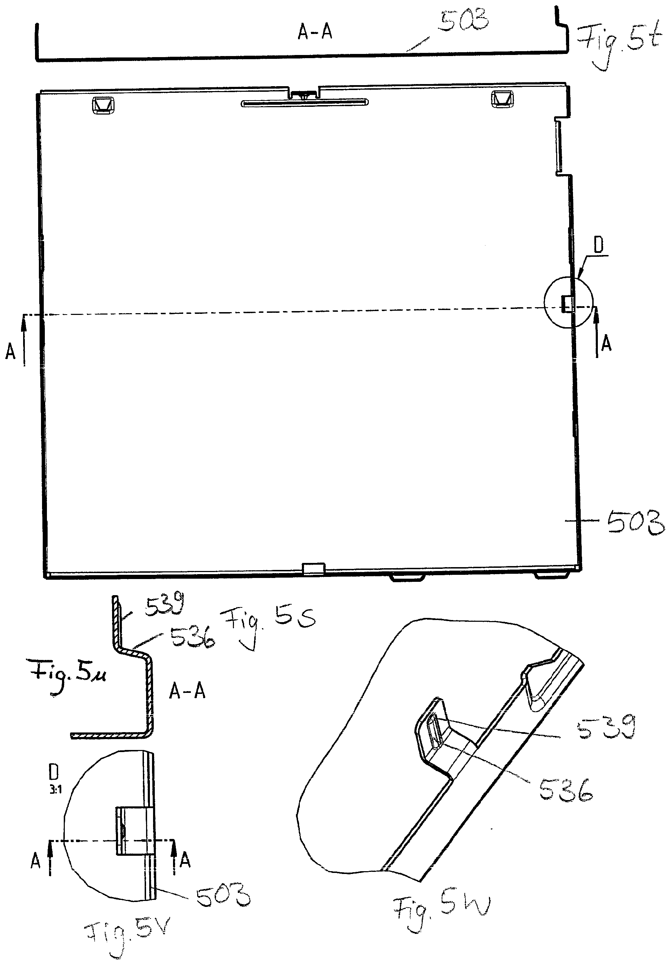

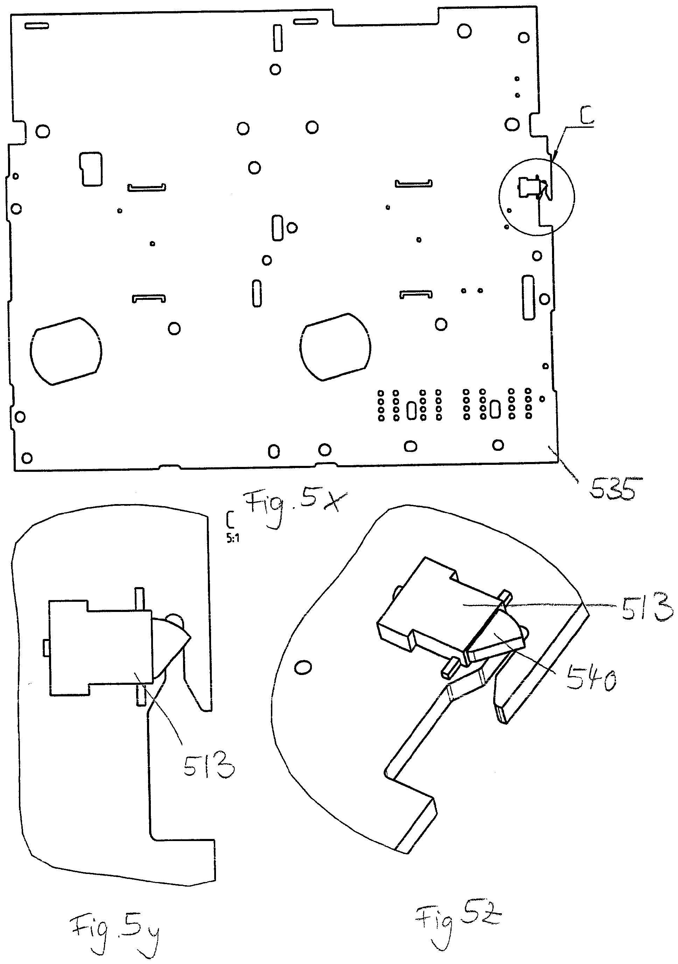

In Detail B (Fig. 5b) ist zu sehen, wie der Schlitz 537 eine zuvor angeordnete Einlaufschräge 538 aufweist und davor angeordnet ein Bereich für die Vormontage einer Betätigungslasche 536 des Gehäusebodens gegeben (hierauf wird später eingegangen) .

Fig. 5d
zeigt eine dreidimensionale Darstellung des Schalters 513 in der Verschlusslage. Der Schalter 513 weist einen hier von einer Lasche 536 verdeckte Schwenkstößel auf. In der hier gezeigten Verschlusslage ragt die Lasche 536, die integraler Bestandteil des Gehäusebodens 503 ist, in den Schlitz hinein. Die Lasche weist eine Ausformung 539 auf, die ihrer Verbreiterung und Versteifung dient. Durch die Einlaufschräge 538 ist ein sicheres verklemmungsfreies Zuführen der Lasche 536 in den Schlitz 537 gegeben. In dieser Lage wird der Schalter 513 in gedrückte Stellung gehalten, d. h., der Schwenkstößel wird in gedrückter Stellung gehalten, so dass die Detektionseinrichtung kein Manipulationssignal abgibt.

Fign. 5e, 5f und 5g
zeigen weitere Details der Anordnung, wobei hier auf die Figuren verwiesen wird.

Besonders in Fig. 5e ist der horizontal liegende Schalter 513, der auf der Leiterplatte 525 montiert ist, gut zu sehen, der Schwenkstößel 540 ist in seiner maximal eingedrückten Position. Der Schwenkstößel 540 ist hierbei gegenüber der Lasche 536 so angeordnet, dass die Lasche möglichst reibungsarm am Schwenkstößel vorbeiläuft und somit keine hohen Querkräfte aufgenommen werden müssen, die sonst zu einem Verkanten des Schalters führen würden.

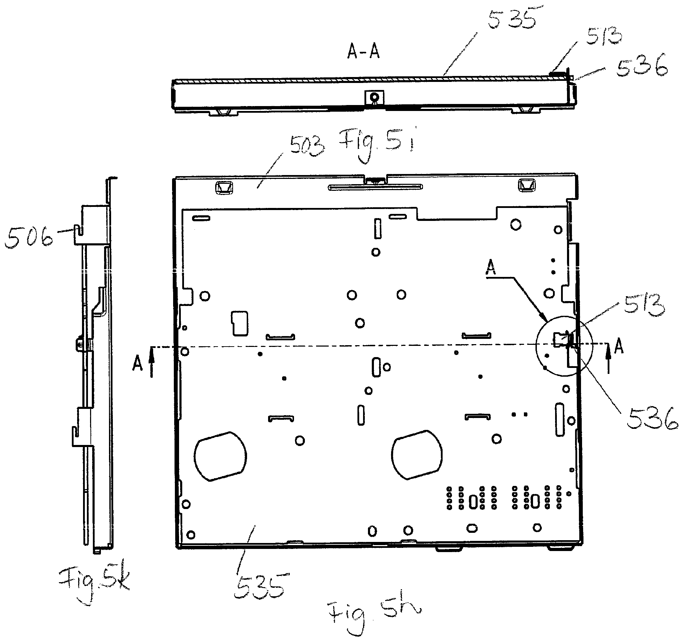

Fign. 5h, 5i und 5k
zeigen Ansichten eines Gehäusebodens 503, auf dem eine Leiterplatte 535 vormontiert ist. Hierbei ist einerseits der Bereich des Schalters 513 sichtbar (siehe Detail A). Außerdem ist, insbesondere in Fig. 5k wiederum die Führung des Gehäusebodens 503 zu dem Rest des Gehäuses (nicht dargestellt) erkennbar. Der Schlitz 506 ist an einer von insgesamt vier Laschen am Gehäuseboden integral angebracht (zwei auf jeder Seite des Gehäusebodens 503). In diese Schlitze 506 greifen jeweils entsprechende Laschen ein, wobei in der Verschlusslage diese Laschen im Wesentlichen vollständig in die Schlitze eingreifen. Bei einem Führen des Gehäusebodens in horizontaler Richtung, also in Richtung der Schlitze, in die Öffnungslage geraten die entsprechenden Laschen außer Eingriff mit den Schlitzen 506, so dass nach Durchlaufen von spätestens 80% der Mindestführungslänge der Schwenkstößel 540 des Schalters 513 außer Eingriff gerät mit der Lasche 536 und somit ein Manipulationssignal von der Detektionseinrichtung abgegeben bzw. auch gespeichert wird.

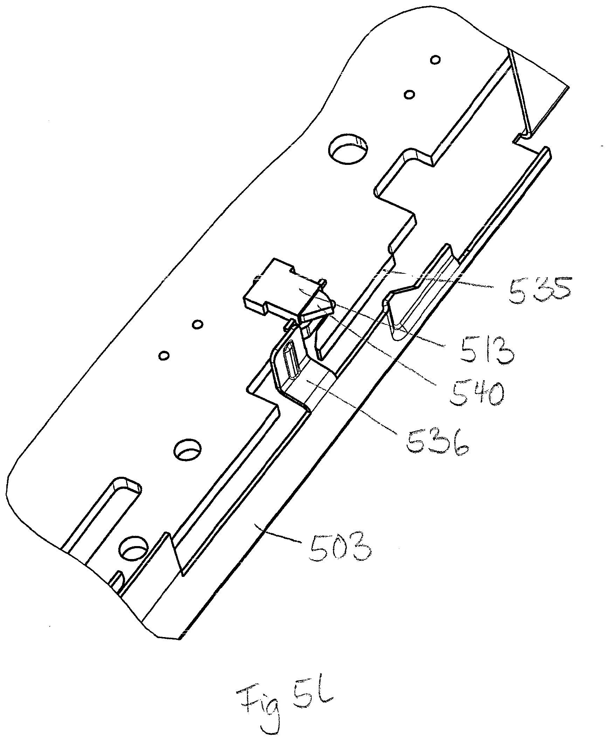

Fig. 5l zeigt
nochmals eine perspektivische Darstellung des Schalterbereichs, wobei hier die Betätigungslasche 536 am Anfang der Einlaufschräge sich befindet, der Gehäuseboden 503 ist noch in der "Montageposition", also einer Öffnungslage. Der Schwenkstößel 540 befindet sich in seiner maximal ausgefahrenen Position und verdeckt im Wesentlichen den Schlitz 537, so dass bei einem Eingriff der Lasche 536 der Schwenkstößel des Schalters betätigt werden muss.

Fign. 5n, 5o und 5m
zeigen weitere Detailansichten dieser Montageposition, bei der der Schwenkstößel 540 noch nicht ausgelöst ist.

Fign. 5p, 5q und 5r
zeigen nochmals den Gehäuseboden 503 mit der darauf angebrachten Leiterplatte 535, allerdings erst in einem vormontierten Zustand (Montageposition, also einer Öffnungslage).

Im Gegensatz zu der Gesamtdarstellung in Fign. 5h, 5i und 5k ist der Schalter 513 nicht ausgelöst.

Fign. 5s, 5t, 5u, 5v und 5w
zeigen nochmals Details der Betätigungslasche 536, die an dem Gehäuseboden 503 angebracht ist. Hieran ist erkennbar, dass die Lasche 536 ein integraler Bestandteil des als Metallblechteil ausgeführten Gehäusebodens 503 ist und senkrecht, allerdings mit einem Winkel in Richtung Binnenraum des Gehäusebodens, nach oben steht, im letzten Abschnitt der Lasche 536 ist die Ausformung 539 angebracht, dies ist besonders gut in Fig. 5u und 5w zu sehen.

Fign. 5x bis 5z
zeigen nochmals Details der Leiterplatte 535 mit dem darauf angebrachten Schalter 513 mit Schwenkstößel 540. Gezeigt ist hier eine nicht ausgelenkte Lage des Schwenkstößels 540. Es hier nochmals gut zu sehen, dass der liegend angeordnete Schalter auf der Leiterplatte 535 angebracht ist und der Schwenkstößel 540 den Schlitz überdeckt.

## Patentansprüche

1. Gehäuse (101), insbesondere Gehäuse für Fahrtenschreiber in Kraftfahrzeugen, enthaltend
- einen durch Bewegung in einer Führung entlang einer Mindestführungslänge (102) aus einer Verschlusslage in eine Öffnungslage von dem restlichen Gehäuse trennbaren Gehäuseboden (103) sowie
- eine elektrische Detektionseinrichtung zum Erkennen des Entfernens des Gehäusebodens,
wobei die Detektionseinrichtung so ausgestaltet ist, dass sie ein Manipulationssignal spätestens nachdem 80 % der Mindestführungslänge aus der Verschlusslage in Richtung Öffnungslage durchlaufen sind, erzeugt, **dadurch gekennzeichnet, dass** eine Leiterplatte (535) einer im Gehäuse (101) angeordneten elektronischen Einrichtung einen Schlitz (537) sowie einen den Schlitz überragenden Schwenkstößel (540) eines mechanischen Schalters (513) aufweist und der Gehäuseboden (503) eine zu dem Schlitz komplementäre Lasche (536) aufweist, die so ausgestaltet ist, dass in der Verschlusslage die Lasche in den Schlitz eingreift und den Schwenkstößel (540) gedrückt hält und dass in einer Öffnungslage der Schwenkstößel (540) sich in seiner maximal ausgefahrenen Position befindet und den Schlitz (537) überdeckt, so dass bei einem Eingriff der Lasche (536) der Schwenkstößel (540) des Schalters (513) betätigt werden muss.

2. Gehäuse nach Anspruch 1, **dadurch gekennzeichnet, dass** das Gehäuse (101) quaderförmig ausgeführt ist.

3. Gehäuse nach Anspruch 1 oder 2, **dadurch gekennzeichnet, dass** der Gehäuseboden (103) an einer beliebigen Fläche des Gehäuses (101) angeordnet sein kann.

4. Gehäuse nach einem der vorhergehenden Ansprüche, **dadurch gekennzeichnet, dass** die Mindestführungslänge mindestens 6,5 mm, vorzugsweise 7,5 mm beträgt.

5. Gehäuse nach einem der vorhergehenden Ansprüche, **dadurch gekennzeichnet, dass** die Führung zwischen Gehäuseboden (103) und dem restlichen Gehäuse als Anordnung ausgeführt ist, bei der mindestens eine Lasche (105) bezüglich eines korrespondierenden Schlitzes (106) translatorisch führbar ist.

6. Gehäuse nach einem der vorhergehenden Ansprüche, **dadurch gekennzeichnet, dass** das Gehäuse (101) eine in einen Kraftfahrzeuginnenraum (107) richtbare Bedienfront (108) aufweist.

7. Gehäuse nach Anspruch 6, **dadurch gekennzeichnet, dass** die Trennung des Gehäusebodens (103) durch translatorische Bewegung in Richtung (109) senkrecht zur Bedienfront (108), an der dem Kraftfahrzeuginnenraum abweisenden Seite möglich ist.

8. Gehäuse nach einem der vorhergehenden Ansprüche, **dadurch gekennzeichnet, dass** der Gehäuseboden (103) ein Metallblechteil ist.

9. Gehäuse nach einem der vorhergehenden Ansprüche, **dadurch gekennzeichnet, dass** der Gehäuseboden (103) zumindest bereichsweise elektrisch leitend ist.

10. Gehäuse nach einem der vorhergehenden Ansprüche, **dadurch gekennzeichnet, dass** das Gehäuse (101) eine elektrische Platine enthaltende Einrichtung zur Speicherung und Verarbeitung von Daten, insbesondere zur Speicherung von streckenbezogenen Daten eines Kraftfahrzeugs, umgibt, wobei vorzugsweise mindestens eine Displayleiterplatte (115), eine Outsertplatine und/oder eine Systemleiterplatte gegeben ist.

11. Gehäuse nach einem der vorhergehenden Ansprüche, **dadurch gekennzeichnet, dass** der Gehäuseboden (103) in Verschlusslage mit dem übrigen Gehäuse (101) zusätzlich verschraubt, verklebt oder durch korrespondierende Rastvorrichtungen verbunden ist.

12. Gehäuse nach einem der vorhergehenden Ansprüche, **dadurch, gekennzeichnet, dass** der Schlitz (537) eine Einlaufschräge (538) hat.

13. Gehäuse nach einem der vorhergehenden Ansprüche, **dadurch gekennzeichnet, dass** die Lasche (536) eine in den Schlitz ragbare Ausformung (539) zur Versteifung und zur Verbreiterung der Lasche aufweist.

## Claims

1. Housing (101), in particular housing for a tachograph in motor vehicles, containing
- a housing base (103) which can be separated from the rest of the housing by movement in a guide along a minimum guide length (102) from a closed position to an open position, and also
- an electrical detection device for identifying the removal of the housing base,
wherein the detection device is configured such that it generates a manipulation signal at the latest after 80% of the minimum guide length from the closed position in the direction of the open position has been traversed, **characterized in that** a printed circuit board (535) of an electronic device which is arranged in the housing (101) has a slot (537) and also a pivoting tappet (540), which protrudes beyond the slot, of a mechanical switch (513), and the housing base (503) has a tab (536) which is complementary to the slot and is configured such that, in the closed position, the tab engages in the slot and holds the pivoting tappet (540) in a pressed manner, and that, in an open position, the pivoting tappet (540) is in its maximally extended position and covers the slot (537), so that the pivoting tappet (540) of the switch (513) has to be operated in the event of engagement of the tab (536).

2. Housing according to Claim 1, **characterized in that** the housing (101) is of cuboidal design.

3. Housing according to Claim 1 or 2, **characterized in that** the housing base (103) can be arranged on any desired surface of the housing (101).

4. Housing according to one of the preceding claims, **characterized in that** the minimum guide length is at least 6.5 mm, preferably 7.5 mm.

5. Housing according to one of the preceding claims, **characterized in that** the guide between the housing base (103) and the rest of the housing is designed as an arrangement in which at least one tab (105) can be guided in a translatory manner with respect to a corresponding slot (106).

6. Housing according to one of the preceding claims, **characterized in that** the housing (101) has a front operator control panel (108) which can be directed into a motor vehicle interior (107).

7. Housing according to Claim 6, **characterized in that** the separation of the housing base (103) is possible by translatory movement in the direction (109) perpendicular to the front operator control panel (108) on that side which is averted from the motor vehicle interior.

8. Housing according to one of the preceding claims, **characterized in that** the housing base (103) is a sheet metal part.

9. Housing according to one of the preceding claims, **characterized in that** the housing base (103) is electrically conductive at least in regions.

10. Housing according to one of the preceding claims, **characterized in that** the housing (101) surrounds a device, which contains electrical printed circuits, for storing and processing data, in particular for storing distance-related data of a motor vehicle, wherein at least one display printed circuit board (115), an outsert circuit board and/or a system printed circuit board are/is preferably provided.

11. Housing according to one of the preceding claims, **characterized in that** the housing base (103) is additionally screwed, adhesively bonded or connected by corresponding latching apparatuses to the rest of the housing (101) in the closed position.

12. Housing according to one of the preceding claims, **characterized in that** the slot (537) has an inlet bevel (538).

13. Housing according to one of the preceding claims, **characterized in that** the tab (536) has a shaped portion (539), which can protrude into the slot, for reinforcing and for widening the tab.

## Revendications

1. Boîtier (101), notamment boîtier pour tachygraphes dans des véhicules automobiles, contenant
- un fond de boîtier (103) qui peut être séparé du reste du boîtier par un mouvement dans un guide le long d'une longueur de guidage minimale (102) depuis une position fermée dans une position ouverte, ainsi
- qu'un dispositif de détection électrique destiné à reconnaître le retrait du fond de boîtier,
le dispositif de détection étant configuré de telle sorte qu'il génère un signal de manipulation au plus tard après que 80 % de la longueur de guidage minimale de la position fermée vers la position ouverte aient été franchis,
**caractérisé en ce que**
un circuit imprimé (535) d'un dispositif électronique disposé dans le boîtier (101) possède une fente (537) ainsi qu'un poussoir pivotant (540) d'un commutateur (513) mécanique qui fait saillie de la fente et le fond de boîtier (503) possède une languette (536) complémentaire de la fente qui est configurée de telle sorte que dans la position fermée, la languette vient en prise dans la fente et maintient le poussoir pivotant (540) enfoncé en que dans une position ouverte, le poussoir pivotant (540) se trouve dans sa position sortie au maximum et recouvre la fente (537), de sorte que le poussoir pivotant (540) du commutateur (513) doit être actionné lors d'un engagement de la languette (536).

2. Boîtier selon la revendication 1, **caractérisé en ce que** le boîtier (101) est réalisé de forme parallélépipédique.

3. Boîtier selon la revendication 1 ou 2, **caractérisé en ce que** le fond de boîtier (103) peut être disposé au niveau d'une surface quelconque du boîtier (101).

4. Boîtier selon l'une des revendications précédentes, **caractérisé en ce que** la longueur de guidage minimale est au moins égale à 6,5 mm, de préférence à 7,5 mm.

5. Boîtier selon l'une des revendications précédentes, **caractérisé en ce que** le guide entre le fond de boîtier (103) et le reste du boîtier est réalisé sous la forme d'un arrangement dans lequel l'au moins une languette (105) peut être guidée en translation par rapport à une fente (106) correspondante.

6. Boîtier selon l'une des revendications précédentes, **caractérisé en ce que** le boîtier (101) possède une face avant de commande (108) qui peut être orientée dans un espace intérieur de véhicule (107).

7. Boîtier selon la revendication 6, **caractérisé en ce que** la séparation du fond de boîtier (103) est possible par un mouvement de translation dans la direction (109) perpendiculaire à la face avant de commande (108) au niveau du côté à l'opposé de l'espace intérieur de véhicule.

8. Boîtier selon l'une des revendications précédentes, **caractérisé en ce que** le fond de boîtier (103) est une pièce en tôle métallique.

9. Boîtier selon l'une des revendications précédentes, **caractérisé en ce que** le fond de boîtier (103) est électriquement conducteur au moins dans certaines zones.

10. Boîtier selon l'une des revendications précédentes, **caractérisé en ce que** le boîtier (101) entoure un dispositif contenant une platine électrique servant à enregistrer et à traiter des données, notamment à enregistrer des données en rapport avec le trajet d'un véhicule automobile, au moins un circuit imprimé d'affichage (115), une platine extérieure et/ou une carte de contrôle de système étant de préférence présents.

11. Boîtier selon l'une des revendications précédentes, **caractérisé en ce que** le fond de boîtier (103) en position fermée est en plus vissé, collé ou assemblé par des arrangements d'encliquetage correspondants avec le reste du boîtier (101) .

12. Boîtier selon l'une des revendications précédentes, **caractérisé en ce que** la fente (537) possède un biseau d'entrée (538) .

13. Boîtier selon l'une des revendications précédentes, **caractérisé en ce que** la languette (536) présente un façonnage (539) qui peut faire saillie dans la fente servant à la rigidification et servant à élargir la languette.
